(19) Europäisches Patentamt / European Patent Office / Office européen des brevets

(11) **EP 3 407 076 B1**

(12) **FASCICULE DE BREVET EUROPEEN**

(45) Date de publication et mention de la délivrance du brevet:
**01.04.2020 Bulletin 2020/14**

(51) Int Cl.:
**G01R 31/26** (2020.01)

(21) Numéro de dépôt: **18173496.3**

(22) Date de dépôt: **22.05.2018**

(54) **PROCEDE DE CARACTERISATION ELECTRIQUE DE TRANSISTOR MOS SUR SOI**

ELEKTRISCHES CHARAKTERISIERUNGSVERFAHREN EINES MOS-TRANSISTORS AUF EINEM SOI-SCHALTKREIS

METHOD FOR ELECTRICALLY CHARACTERISING A SOI-MOS TRANSISTOR

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **23.05.2017 FR 1754559**

(43) Date de publication de la demande:
**28.11.2018 Bulletin 2018/48**

(73) Titulaire: **Commissariat à l'Energie Atomique et aux Energies Alternatives**
**75015 Paris (FR)**

(72) Inventeurs:
• **LEROUX, Charles**
  **38360 NOYAREY (FR)**
• **MOHAMAD, Blend**
  **22036 ERBA (IT)**

(74) Mandataire: **Cabinet Camus Lebkiri**
**25 rue de Maubeuge**
**75009 Paris (FR)**

(56) Documents cités:
US-A1- 2007 052 037    US-A1- 2009 132 974
US-A1- 2012 105 095    US-A1- 2015 129 973

• MOHAMAD B ET AL: "Reliable gate stack and substrate parameter extraction based on C-V measurements for 14nm node FDSOI technology", SOLID STATE ELECTRONICS, vol. 128, 15 octobre 2016 (2016-10-15), pages 10-16, XP029861961, ISSN: 0038-1101, DOI: 10.1016/J.SSE.2016.10.010

• LEROUX ET AL: "Accurate determination of flat band voltage in advanced MOS structure", MICROELECTRONICS AND RELIABILITY, ELSEVIER SCIENCE LTD, GB, vol. 47, no. 4-5, 21 avril 2007 (2007-04-21), pages 660-664, XP022042384, ISSN: 0026-2714, DOI: 10.1016/J.MICROREL.2007.01.033

• MIN-KYU JOO ET AL: "Flat-band voltage and low-field mobility analysis of junctionless transistors under low-temperature", SEMICONDUCTOR SCIENCE AND TECHNOLOGY, IOP PUBLISHING LTD, GB, vol. 29, no. 4, 5 mars 2014 (2014-03-05), page 45024, XP020259895, ISSN: 0268-1242, DOI: 10.1088/0268-1242/29/4/045024 [extrait le 2014-03-05]

• BEN AKKEZ I ET AL: "New parameter extraction method based on split C-V for FDSOI MOSFETs", SOLID-STATE DEVICE RESEARCH CONFERENCE (ESSDERC), 2012 PROCEEDINGS OF THE EUROPEAN, IEEE, 17 septembre 2012 (2012-09-17), pages 217-220, XP032466603, DOI: 10.1109/ESSDERC.2012.6343372 ISBN: 978-1-4673-1707-8

• SORIN CRISTOLOVEANU ET AL: "A Review of the Pseudo-MOS Transistor in SOI Wafers: Operation, Parameter Extraction, and Applications", IEEE TRANSACTIONS ON ELECTRON DEVICES, IEEE SERVICE CENTER, PISCATAWAY, NJ, US, vol. 47, no. 5, 1 mai 2000 (2000-05-01), XP011017234, ISSN: 0018-9383

- FASARAKIS NIKOLAOS ET AL: "Analytical Modeling of Threshold Voltage and Interface Ideality Factor of Nanoscale Ultrathin Body and Buried Oxide SOI MOSFETs With Back Gate Control", IEEE TRANSACTIONS ON ELECTRON DEVICES, IEEE SERVICE CENTER, PISACATAWAY, NJ, US, vol. 61, no. 4, 1 avril 2014 (2014-04-01), pages 969-975, XP011543523, ISSN: 0018-9383, DOI: 10.1109/TED.2014.2306015 [extrait le 2014-03-20]
- SVILII B ET AL: "Analysis of subthreshold conduction in short-channel recessed source/drain UTB SOI MOSFETs", SOLID STATE ELECTRONICS, ELSEVIER SCIENCE PUBLISHERS, BARKING, GB, vol. 54, no. 5, 18 février 2010 (2010-02-18), pages 545-551, XP026965977, ISSN: 0038-1101 [extrait le 2010-02-18]
- TOFFOLI A ET AL: "ACCURATE DETERMINATION OF THE MAIN PARAMETERS FROM VT(VB) CURVES OF FULLY-DEPLETED SOI DEVICES", PROCEEDINGS OF THE INTERNATIONAL CONFERENCE ON MICROELECTRONIC TEST STRUCTURES (ICMTS). NARA, JP., MAR. 22 - 25, 1995; [PROCEEDINGS OF THE INTERNATIONAL CONFERENCE ON MICROELECTRONIC TEST STRUCTURES (ICMTS)], NEW YORK, IEEE, US, 22 mars 1995 (1995-03-22), pages 71-76, XP000547644, ISBN: 978-0-7803-2066-6
- SARKHEL SAHELI ET AL: "A compact capacitive approach based threshold voltage modeling and performance comparison of a novel UBR MOSFET with SOI MOSFET", 2014 2ND INTERNATIONAL CONFERENCE ON DEVICES, CIRCUITS AND SYSTEMS (ICDCS), IEEE, 6 mars 2014 (2014-03-06), pages 1-5, XP032661812, DOI: 10.1109/ICDCSYST.2014.6926216
- BAWEDIN M ET AL: "Dynamic body potential variation in FD SOI MOSFETs operated in deep non-equilibrium regime: Model and applications", SOLID STATE ELECTRONICS, ELSEVIER SCIENCE PUBLISHERS, BARKING, GB, vol. 54, no. 2, 1 février 2010 (2010-02-01), pages 104-114, XP026904421, ISSN: 0038-1101, DOI: 10.1016/J.SSE.2009.12.004 [extrait le 2010-01-12]

**Description**

**DOMAINE DE L'INVENTION**

La présente invention se situe dans le domaine de la caractérisation électrique des transistors formés par un empilement de type métal/oxyde/semiconducteur ou MOS. Un objet de la présente invention est un procédé de mesure d'un jeu de paramètres d'un transistor de type MOS sur substrat de type SOI (Silicon on Insulator). Selon un aspect de l'invention ledit jeu de paramètres comprend la tension de bandes plates à la face arrière de l'oxyde enterré. Selon un autre aspect de l'invention ledit jeu de paramètres comprend l'épaisseur équivalente d'oxyde EOT (« Equivalent Oxide Thickness » en anglais) ainsi que le travail de sortie du métal de grille avant Weff.

**ETAT DE L'ART**

Les industries de la microélectronique engagées dans le développement de filières CMOS (« Complementary Metal Oxide Semiconductor » en anglais) ont besoin d'outils efficaces pour comparer des technologies variées ayant des architectures spécifiques.

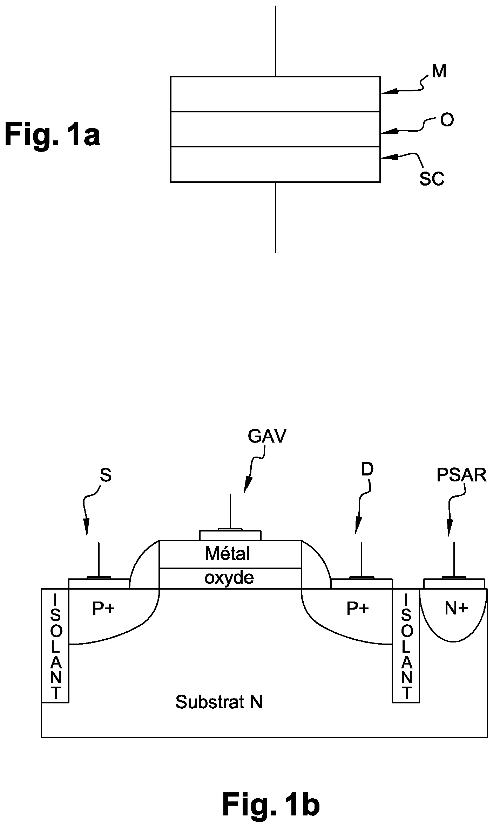

La figure 1a montre un empilement MOS formé par un métal M, un oxyde O et un semi-conducteur S. La figure 1b montre un transistor obtenu à partir d'un empilement MOS sur substrat massif sur silicium. La figure 1b montre notamment les électrodes de source S et drain D, la grille face avant GAV et la prise substrat face arrière PSAR.

Deux paramètres souvent utilisés dans la caractérisation des transistors MOS sont la tension de seuil Vth du transistor et l'épaisseur équivalente de capacité à tension donnée CET. Toutefois, il reste difficile de comparer deux assemblages différents sur la base de ces deux paramètres car la CET est couplée à Vth. Ce dernier dépend aussi du substrat, voire de sa polarisation. Une comparaison de transistors MOS sur SOI mais aussi sur bulk fabriqués avec des procédés différents à partir de paramètres tels que la CET et Vth est considérée peu fiable.

Une approche alternative consiste à prendre en compte deux autres paramètres, à savoir l'épaisseur d'oxyde équivalent EOT et le travail de sortie effectif du métal de grille Weff. Ces deux paramètres sont définis comme étant respectivement l'épaisseur de l'oxyde et le travail de sortie effectif du métal de grille d'un empilement MOS idéal ayant le même comportement électrique que le dispositif que l'on caractérise. Cet empilement MOS idéal de référence est constitué d'un métal, d'un diélectrique en oxyde de silicium ayant une constante diélectrique connue de $3,9*8,85*10^{-12}$ F/m et d'un substrat semi-conducteur. L'oxyde de silicium de cet empilement MOS est considéré comme parfait, sans charges et sans dipôles à ses interfaces.

Les deux paramètres EOT et Weff définissent donc un langage commun pour comparer deux technologies différentes. Par exemple, une comparaison à partir de EOT et Weff permet de mettre en évidence des phénomènes de croissance de diélectrique ou de décalage électrique des polarisations de référence, tels que la présence de charges dans les diélectriques, de dipôles aux interfaces ou de modifications du travail de sortie du métal de grille.

L'EOT et le Weff sont donc des paramètres fondamentaux pour les technologues qui leur permettent de suivre de manière pertinente le procédé de l'empilement MOS et d'ajuster les performances du transistor MOS. Ces deux paramètres permettent de suivre directement l'épaisseur du diélectrique et le travail de sortie équivalent de la grille qui est posée dessus. Il s'agit donc de deux bras de levier essentiels pour un technologue pour ajuster les performances du transistor MOS. Ils sont couramment suivis dans les études de technologies des procédés (« process Technology »).

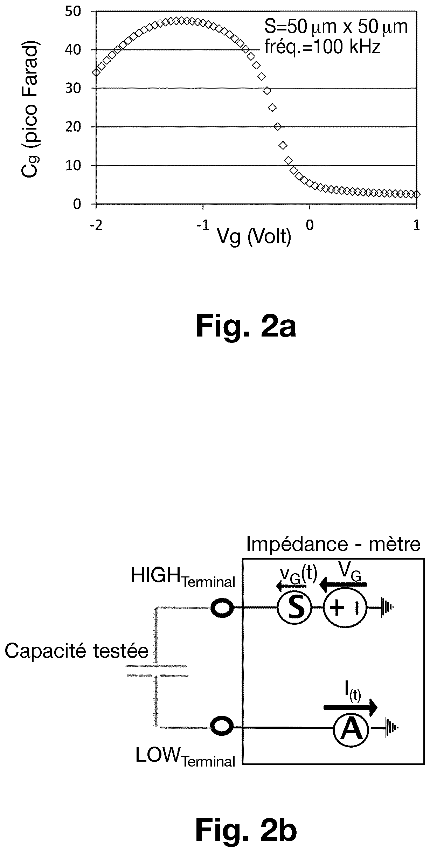

L'EOT et le Weff peuvent être extraits à partir d'une mesure expérimentale de la capacité du dispositif que l'on veut caractériser en fonction de la tension appliquée au métal de grille ou caractéristique C(V). Une telle mesure peut être réalisée en utilisant le montage expérimental de la figure 2b.

Pour une caractéristique C(V) expérimentale telle que celle montrée à la figure 2a, extraire l'EOT et Weff revient donc à trouver respectivement l'épaisseur de diélectrique et le travail de sortie du métal de l'empilement MOS idéal qui a le même comportement électrique que le dispositif que l'on caractérise.

Dans le cas d'un empilement MOS sur substrat massif, une caractéristique C(V) donnée est univoquement déterminée à partir d'un ensemble de trois paramètres formé par l'EOT, le dopage du substrat et la tension de bandes plates Vfb. Ce dernier paramètre est la tension appliquée sur la grille respectivement au substrat et aux source et drain pour laquelle la charge dans le semi-conducteur est nulle. Le paramètre Weff est ensuite calculé à partir de l'ensemble de trois paramètres identifié grâce à la mesure de C(V), essentiellement le dopage et la tension de bandes plates.

Traditionnellement les paramètres EOT et Weff sont obtenus à partir d'une analyse directe de cette caractéristique C(V) et en faisant des calculs à partir de plusieurs points de cette courbe expérimentale, souvent les capacités maximum et minimum. Ces méthodes sont listées dans « Accurate détermination of flat band voltage in advanced MOS structures » de C. Leroux et al. publié dans Microelectronics Reliability 47, 2007 pages 660-664.

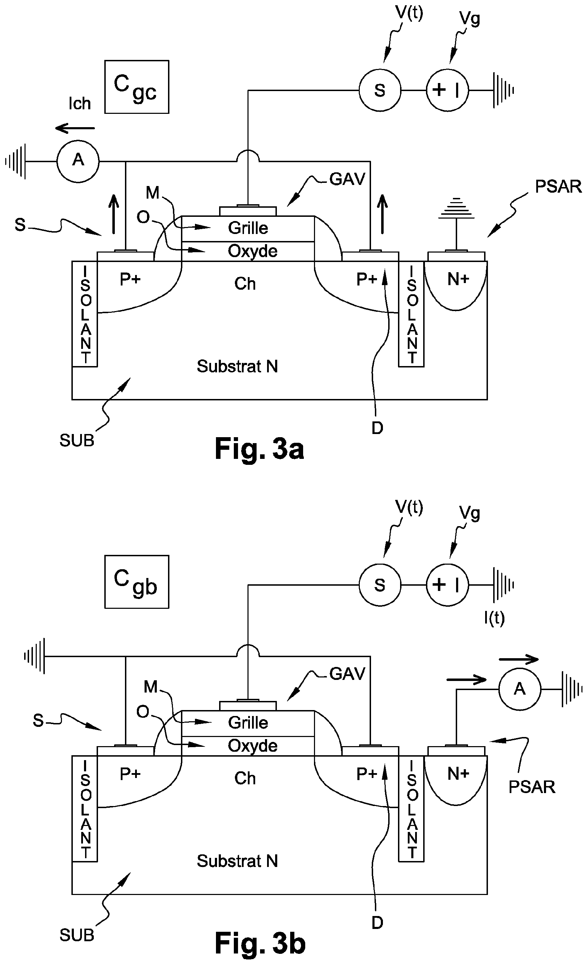

La figure 2a montre un exemple de caractéristique C(V) obtenue pour un empilement MOS déposé sur un substrat massif tel que celui illustré aux figures 1a et 1b. La courbe de la figure 2a est obtenue de façon connue avec le montage expérimental montré en figure 2b. Ce montage comprend un impédance-mètre dont les terminaux sont branchés sur la capacité à déterminer. Les figures 3a et 3b illustrent les deux types de capacités qui peuvent être mesurées avec le montage de la figure 2b. Il s'agît de la capacité Cgc, entre grille face avant GAV et canal Ch, illustrée à la figure 3a et de la capacité Cgb entre la grille face avant GAV et la prise substrat face arrière PSAR, illustrée à la figure 3b. Dans les deux cas une tension continue Vg et une tension alternative v(t) sont appliquées à la grille face avant GAV.

La courbe expérimentale illustrée à la figure 2a est la capacité entre grille et substrat Cgb de figure 3b. Cette mesure est réalisée pour un empilement MOS sur substrat massif de type P.

Les méthodes analytiques permettant d'extraire les paramètres Weff et EOT sont décrites par exemple dans l'article « Accurate détermination of flat band voltage in advanced MOS structures » de C. Leroux et al. publié dans Microelectronics Reliability 47 (2007) pages 660-664.

La diminution des dimensions, en particulier l'épaisseur des oxydes, et l'utilisation de nouveaux semi-conducteurs a nécessité de prendre en compte les effets quantiques et les structures de bande propres à ces semi-conducteurs. Dès lors, pour une caractéristique capacité tension C(V) expérimentale les paramètres d'EOT et Weff ont été extraits en recherchant la simulation numérique d'un empilement MOS idéal qui s'ajuste à l'expérience.

Néanmoins, cette méthode peut s'avérer fastidieuse car elle nécessite pour chaque technologie et chaque mesure une simulation numérique qui en soit représentative puis des essais sur EOT et Weff pour obtenir un bon ajustement entre les deux caractéristiques expérimentales et simulées.

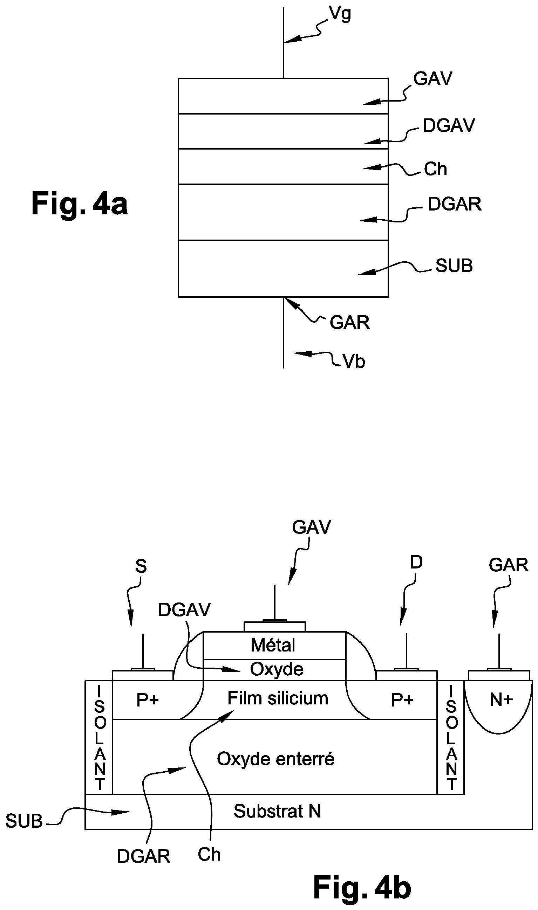

Mais bien plus, les méthodes connues rencontrent plusieurs difficultés sérieuses dans le cas des empilements MOS sur substrat SOI tel que l'empilement illustré aux figures 4a et 4b.

L'empilement MOS sur SOI illustré à la figure 4a est formé par un métal constituant la grille face avant GAV, un oxyde ou diélectrique de grille face avant DGAV, une couche de semi-conducteur formant le canal Ch, un deuxième oxyde ou diélectrique de grille face arrière DGAR et un substrat semi-conducteur SUB. La tension appliquée à la grille face avant est appelée polarisation de grille face avant PGAV ou tension de grille Vg et la tension appliquée à la grille face arrière est appelée polarisation de grille face arrière PGAR ou tension de grille face arrière Vb.

Le transistor MOS sur SOI de la figure 4b est obtenu à partir d'un empilement du type illustré à la figure 4a.

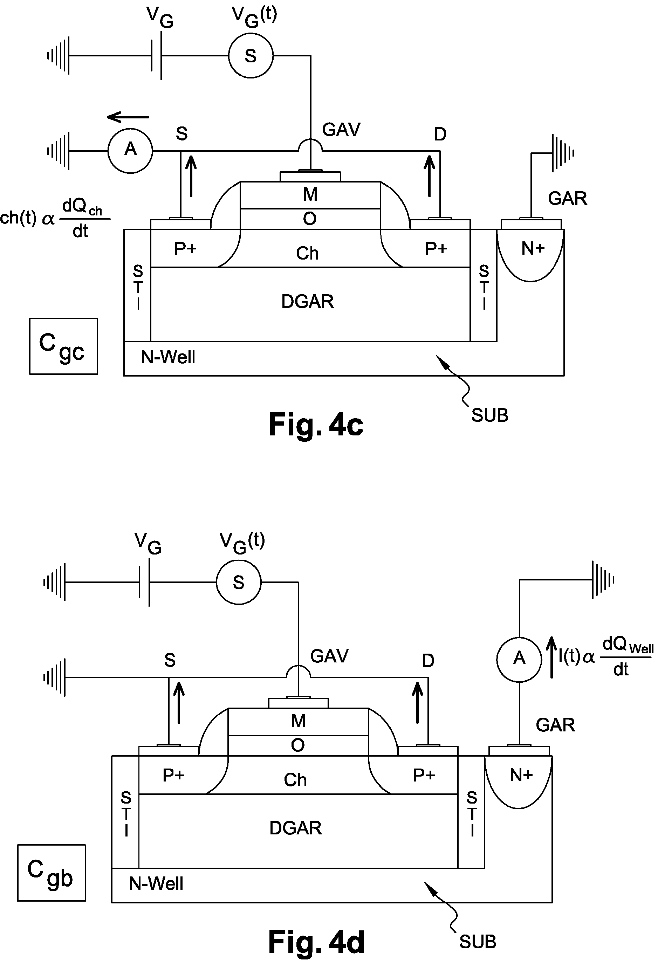

Les figures 4c et 4d montrent les montages expérimentaux pour mesurer Cgc et Cgb dans le cas d'un empilement MOS sur SOI.

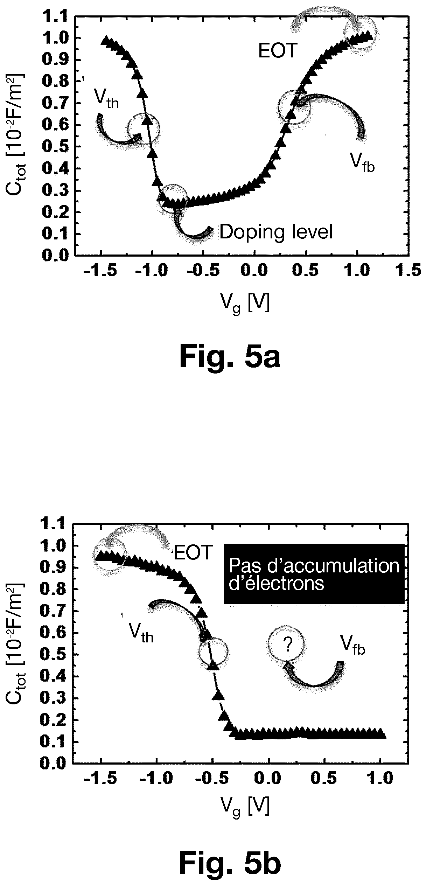

Tout d'abord la caractéristique C(V) relative à un empilement MOS sur SOI montre une variation avec la tension réduite par rapport à la même mesure relative à un empilement MOS sur substrat massif. En effet, si la caractéristique bulk donnait des signaux dans les trois régimes d'accumulation, de déplétion et d'inversion, la caractéristique SOI ne donne accès qu'à la partie inversion de canal. Ceci est par exemple illustré à la figure 5a qui montre une caractéristique C(V) pour un empilement MOS, à comparer avec la figure 5b qui montre une caractéristique C(V) pour un empilement MOS sur SOI. Cette différence empêche dans le cas de l'empilement MOS sur SOI de déterminer les trois paramètres Vfb, Weff et EOT à partir de l'étude de points spécifiques de la caractéristique C(V), puisque la tension de bandes plates n'est plus accessible car se trouvant dans une gamme de polarisation pour laquelle le signal de capacitif n'est pas représentatif.

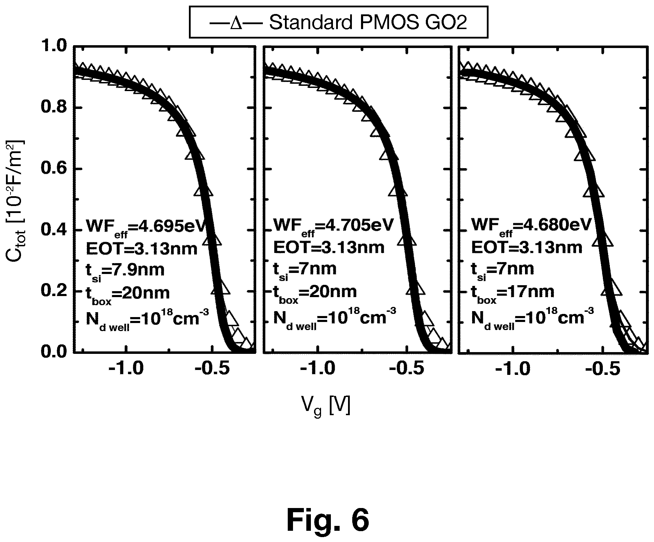

Par ailleurs, la méthode de l'ajustement de la caractéristique Cgc(Vg) avec un modèle théorique ne donne pas non plus des résultats très satisfaisants. Par exemple, la figure 6 (issue du document « Reliable Gate Stack and Substrate Parameter Extraction based on C-V measurements for 14 nm node FDSOI technology » de M. Mohamad et al.) montre qu'à partir d'une même caractéristique C(V) il est possible d'obtenir plusieurs jeux de paramètres lors de l'ajustement entre la mesure et le modèle. Il est notamment possible d'obtenir plusieurs valeurs de travail de sortie Weff selon les valeurs que l'on suppose pour des paramètres spécifiques d'un empilement MOS sur SOI.

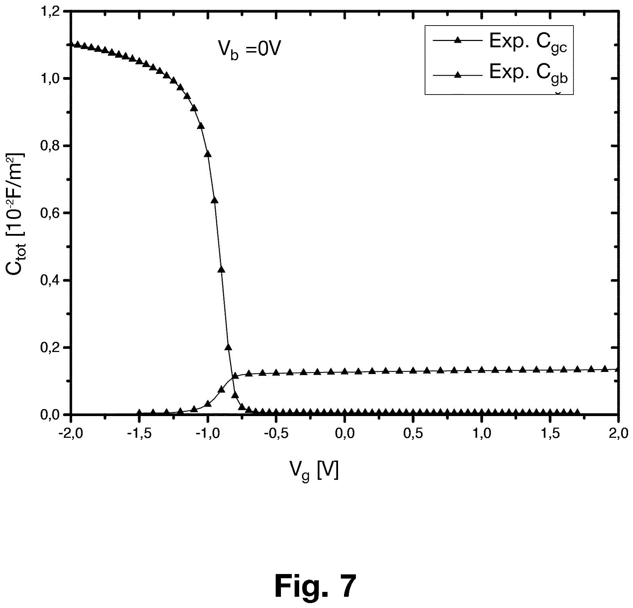

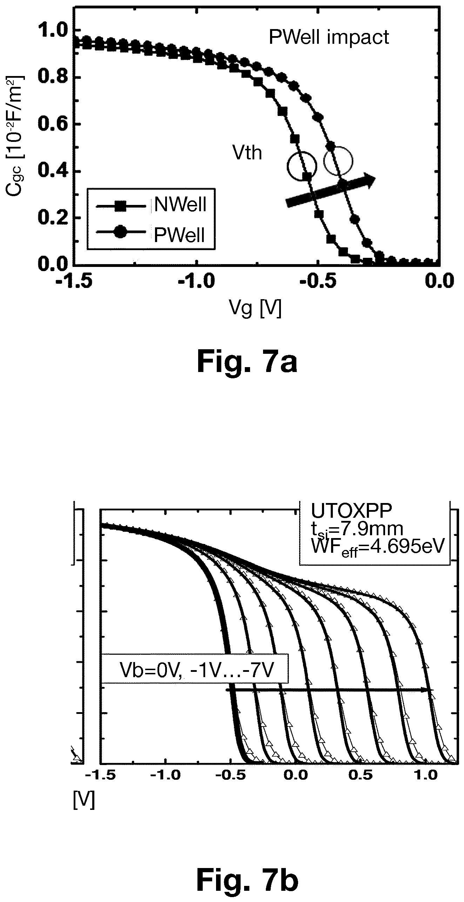

Non seulement l'identification d'un jeu de paramètres unique décrivant la structure MOS sur SOI n'est pas possible par la simulation, mais la mesure elle-même semble ne pas être unique pour un même empilement de grille. On rapporte en figure 7a pour un même empilement technologique (grille métal GAV, diélectrique DGAV, film semi-conducteur Ch, oxyde enterré DGAR), les différentes caractéristiques que l'on obtient selon le substrat SUB qui se trouve en face arrière de l'oxyde enterrée, ou en figure 7b selon la polarisation de grille Vb de ce substrat SUB. On voit qu'il est possible de décaler de manière sensible de plusieurs centaines de millivolts les caractéristiques C(V). L'extraction des paramètres EOT et Weff à partir de la seule capacité Cgc(Vg) rencontrent donc de sérieux obstacles sur substrat SOI.

Autrement dit, une mesure sur substrat SOI sur la base d'une seule caractéristique Cgc(Vg) et sans tenir compte de son contexte de mesure (épaisseur de canal Ch, épaisseur d'oxyde enterré DGAR, nature du substrat SUB à la face arrière et sa polarisation,...) conduit à une mesure de Weff qui peut être erronée ou peu reproductible.

Les méthodes connues pour l'extraction des paramètres EOT et Weff à partir de la caractéristique C(V) mesurée ne sont pas précises et fiables dans le cas d'un empilement MOS sur substrat SOI, ce qui rend ces mesures peu adaptées pour devenir des outils d'analyse statistique des transistors lors de leur production.

## RESUME DE L'INVENTION

L'invention vise à résoudre ces problèmes grâce à un procédé permettant l'extraction de façon fiable et reproductible des paramètres Weff et EOT pour un empilement MOS sur substrat SOI. Le procédé selon l'invention permet en outre de déterminer la tension de bandes plates à la face arrière de l'oxyde enterré, ce qui n'est pas possible avec les méthodes connues de l'homme du métier.

Un premier objet de l'invention est un procédé de mesure d'un jeu de paramètres d'un transistor de type MOS sur substrat de type SOI (Silicon On Insulator), ledit jeu de paramètres incluant au moins la tension de bandes plates Vfb à la face arrière de l'oxyde enterré, ledit procédé comprenant les étapes suivantes :

- appliquer à la grille face avant GAV du transistor une tension principale continue Vgs et une tension alternative v(t), la tension principale continue Vgs pouvant balayer une plage de valeurs prédéterminée ;
- appliquer en outre une tension -Vbias à la grille face avant GAV et aux électrodes source S et drain D, la tension -Vbias pouvant balayer une plage de valeurs prédéterminée ;
- pour une valeur de la tension -Vbias donnée, mesurer le courant électrique Ig(t) issu de la grille face arrière en fonction de Vgs et déterminer à partir de cette mesure la capacité Cgb entre la grille face avant et la face arrière du substrat du transistor, de façon à obtenir la caractéristique $C_{gb,Bias}$(Vgs ; Vbias) ;
- faire varier la valeur de la tension -Vbias et pour chaque valeur de Vbias mesurer la caractéristique $C_{gb,Bias}$(Vgs ; Vbias) en faisant varier Vgs de sorte à obtenir un ensemble de caractéristiques $C_{gb,Bias}$(Vgs ; Vbias), chaque caractéristique correspondant à une valeur de -Vbias différente ;
- à partir de l'ensemble de caractéristiques $C_{gb,Bias}$(Vgs ; Vbias), déterminer l'ensemble de caractéristiques $C_{gb,Bias}$(Vgb ; Vbias), Vgb étant la tension entre la grille face avant et la grille face arrière ;
- déterminer la caractéristique $C_{gb,Bias}$(Vgb), cette caractéristique étant l'enveloppe de l'ensemble de caractéristiques $C_{gb,Bias}$(Vgb ; Vbias) ;
- déterminer le jeu de paramètres en réalisant un ajustement entre la caractéristique $C_{gb,Bias}$(Vgb) et un modèle théorique décrivant le comportement d'un transistor de type MOS sur substrat massif, ledit ajustement étant limité à la plage de valeurs de Vgb pour lesquels le canal du transistor est en régime de déplétion.

On entend par un transistor de type MOS (Métal/Oxyde/Semi-conducteur) sur substrat SOI (Silicon on Insulator) un transistor MOS dans lequel la couche de semi-conducteur ou canal semi-conducteur Ch du MOS est formée sur une couche diélectrique telle qu'une couche d'oxyde. Cette couche diélectrique est appelée également diélectrique de grille arrière DGAR.

Le diélectrique de grille arrière DGAR supportant le canal semi-conducteur Ch du MOS est situé au-dessus d'une couche de semi-conducteur appelée substrat SUB du transistor MOS sur SOI. Pour cette raison le diélectrique de grille arrière DGAR est également appelé oxyde enterré.

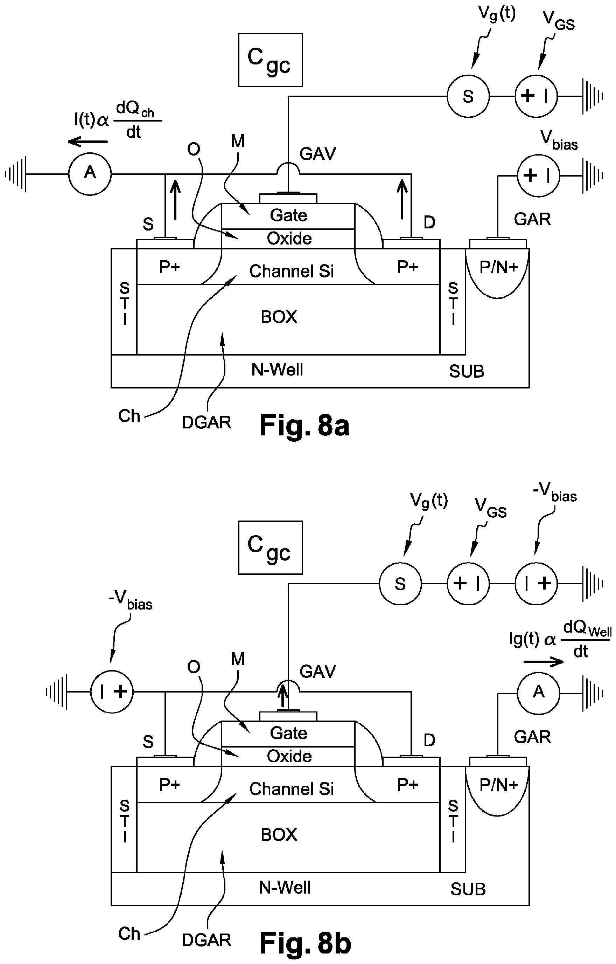

La structure d'un transistor de type MOS sur SOI est illustrée aux figures 4a, 4b, 8a et 8b. La figure 8b montre le montage expérimental pour la mise en œuvre du procédé selon l'invention.

On entend par $C_{gb,Bias}$(Vgs ; Vbias) une mesure de la capacité entre grille face avant GAV et grille face arrière GAR grâce au montage de la figure 8b. En particulier, la caractéristique $C_{gb,Bias}$(Vgs ; Vbias) est obtenue en faisant varier la tension Vgs et en fixant la valeur de la tension Vbias.

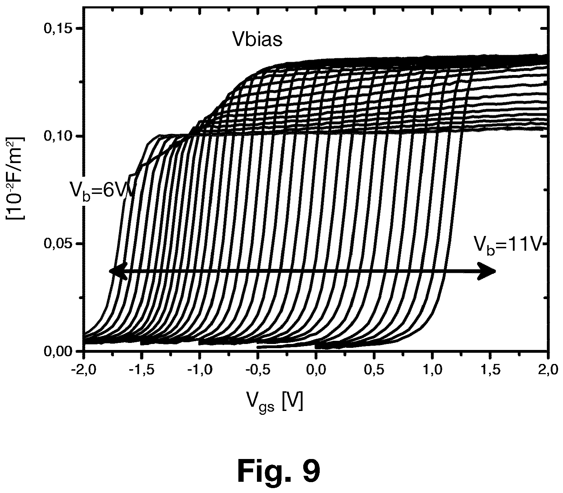

On entend par ensemble de caractéristiques $C_{gb,Bias}$(Vgs ; Vbias) plusieurs caractéristiques $C_{gb,Bias}$(Vgs ; Vbias), chaque caractéristique étant obtenue pour une valeur fixée de Vbias et en faisant varier Vgs. Un tel ensemble de caractéristiques est illustré par exemple à la figure 9.

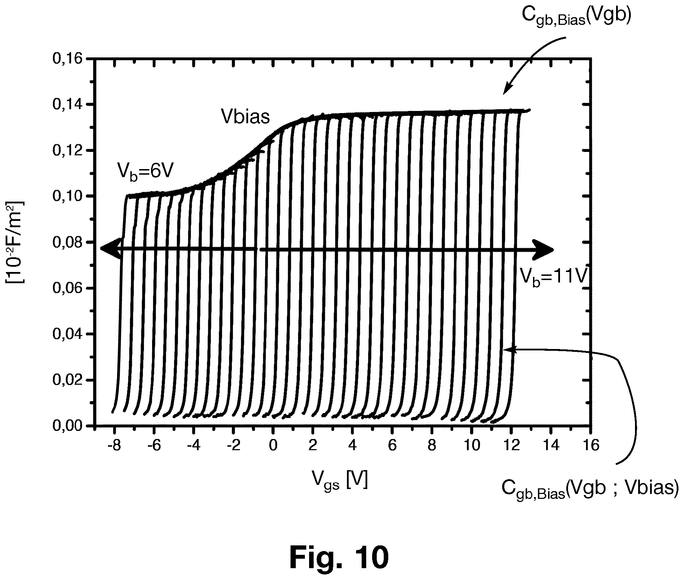

On entend par enveloppe de l'ensemble de caractéristiques $C_{gb,Bias}$(Vgb ; Vbias) une courbe tangente à chacune des courbes de l'ensemble. Un exemple d'un tel enveloppe est la courbe $C_{gb,Bias}$(Vgb) illustrée à la figure 10.

La structure d'un transistor de type MOS sur substrat massif est illustrée aux figures 1a et 1b.

On entend par face arrière du substrat du transistor la surface externe du substrat SUB semi-conducteur. Une électrode est appliquée sur cette surface externe pour l'application d'une tension Vb de polarisation de grille face arrière nulle sur laquelle on mesure le courant comme dans le cas de la mesure de la figure 8b ou d'une tension de polarisation Vbias dans le cas du montage de la figure 8a.

On entend par grille face avant GAV la couche métallique M de l'empilement MOS.

On entend par grille face arrière GAR l'électrode appliquée sur la face arrière du substrat SUB d'un empilement MOS sur SOI.

On entend par tension de bandes plates Vfb à la face arrière de l'oxyde enterrée DGAR la différence entre la tension Vgs appliquée à la grille face avant GAV et la tension appliquée sur l'électrode GAR et pour laquelle la charge dans le substrat semi-conducteur SUB est nulle.

On entend par modèle théorique décrivant le comportement d'un transistor de type MOS sur substrat massif un modèle pour le calcul de la caractéristique Cgb(Vgb) dans le cas d'un transistor MOS sur substrat massif.

La mesure du courant Ig(t) issu de la grille face arrière GAR permet de déterminer à l'aide d'un impédance-mètre la capacité $C_{gb,Bias}$(Vgs ; Vbias), à savoir la capacité entre la grille face avant GAV et la face arrière du substrat GAR.

Pour comprendre le principe de l'invention, nous allons d'abord expliquer en détail pourquoi des mesures d'une caractéristique C(V) réalisées avec un montage standard tel que celui des figures 4c et 4d ne permettent pas de déterminer de façon simple les paramètres d'intérêt. Autrement dit, le procédé selon l'invention permet de simplifier la détermination de paramètres tels que la tension de bandes plates, l'EOT et le Weff dans le cas d'un empilement MOS sur SOI.

Les figures 4c et 4d montrent que deux capacités différentes peuvent être mesurées avec le montage de figure 2b : la capacité Cgb entre grille face avant GAV et semi-conducteur massif ou bulk, et la capacité Cgc entre grille face avant GAV et canal Ch.

Dans les deux cas, on utilise l'impédance-mètre de la figure 2b. Cet appareil permet de superposer sur l'un de ses terminaux une tension petit signal vg(t) alternative à une tension principale Vg continue. Cette tension est connectée à la grille face avant GAV des figures 4c et 4d.

Dans le cas de la figure 4c, le deuxième terminal de l'impédance-mètre est connecté aux électrodes source S et drain D du transistor MOS. Il est donc possible de mesurer le courant Ich(t) collecté par source S et/ou drain D et remonter à la caractéristique Cgc(Vg).

Dans le cas de la figure 4d, le deuxième terminal de l'impédance-mètre est connecté à la face arrière GAR du substrat semi-conducteur et il est possible de remonter à la caractéristique Cgb(Vg).

Les deux capacités Cgc et Cgb étant en parallèle, il est possible de réaliser les deux montages de figure 4c et 4d en même temps pour mesurer la capacité totale Ct(Vg), Ct étant la somme de Cgc et Cgb.

Nous considérons d'abord le cas d'un transistor du type MOS sur substrat massif comme celui montré à la figure 3a et à la figure 3b. On considère ici un substrat de type N, dans lequel les porteurs majoritaires sont les électrons.

Un empilement MOS comprend deux capacités en série : la capacité diélectrique Cox et la capacité du semi-conducteur Csc. Si on connaît la relation entre la charge dans le semi-conducteur Qsc et la chute de potentiel interne à ses bornes $\psi_{SC}$, on peut calculer Csc = dQsc/d$\psi_{SC}$. La capacité totale du système peut alors être calculée :

$$1/\,C_g(Q_{sc}){=}1/C_{ox}{+}1/C_{sc}(Q_{sc}) \quad (1)$$

Quand on augmente la tension Vg pour un semi-conducteur de type P (respectivement N), le substrat SUB passe successivement d'une accumulation de trous (respectivement inversion de trous) à une déplétion puis une inversion d'électron (respectivement accumulation d'électrons). Il y a donc un moment où la charge du substrat SUB est nulle. Du point de vue de la simulation, cela veut dire Qsc =0 ou, dit autrement, une situation de bandes d'énergie plates à l'interface semi-conducteur/diélectrique. Cette tension est la tension de bandes plates Vfb. La charge dans les électrodes pour n'importe quelle autre tension peut donc se calculer par intégration de la capacité du système à partir de cette tension dite de bandes plates :

$$Q_{SC}\big(V_g\big) = -Q_g\big(V_g\big) = -\int_{Vfb}^{Vg} Cg.\,dV \quad (2)$$

La capacité Cg de l'équation (2) est la capacité totale Ctot. Toutefois si on travaille en accumulation/déplétion la capacité Cgb est suffisante.

En outre la chute de tension Vg correspond, aux travaux de sortie près, à la chute de tension dans le diélectrique $V_{OX}$ plus celle dans le semi-conducteur $\psi_{SC}$. Ce qui conduit à l'équation 3 :

$$V_g{=}\ W_{F,M}/q - W_{F,S}/q{+}\ \Psi_{sc} +\ V_{ox} \qquad (3)$$

q étant la charge de l'électron

Cette expression s'explicite en tenant compte de la relation entre la charge aux électrodes et la chute de tension dans le diélectrique Vox =- Qsc/Cox. $W_{F,M}$ et $W_{F,S}$ sont des données des matériaux de chacune des électrodes, leur travail de sortie. Ainsi pour un semi-conducteur dopé à un niveau Nsc, on peut calculer $W_{F,S}$ pour la température ambiante (T=300°K) avec $W_{F,S}$ = 4,61 eV +L. k.T. In (Nsc /ni) avec ni dopage intrinsèque du silicium, couramment ni= 1010 /cm3 à 300°K et k constante de Boltzmann 1,38.10-23 J/°K, avec L valant +1 pour un substrat P et -1 pour un substrat N, on arrive alors à :

$$Vg(Qsc)= W_{F,M}/q - W_{F,S}/q + \psi_{sc}(Qsc) - Qsc/Cox \quad (4)$$

On a, par ailleurs, défini Vfb comme la tension de grille pour laquelle la charge dans le semi-conducteur est nulle, il s'ensuit :

$$V_g(Qsc)= Vfb + \psi_{sc}(Qsc) - \psi_{sc}(Vfb) - Q_{sc}/Cox \quad (5)$$

Weff étant le travail de sortie d'une grille idéale rendant compte de la même caractéristique, il s'ensuit:

$$Weff/q = Vfb - \psi_{sc}(Vfb) + W_{F,S}/q \quad (6)$$

Ce qui amène à réécrire l'équation 5 en :

$$Vg(Qsc)= Weff/q - W_{F,S}/q + \psi_{sc}(Qsc) - Qsc/Cox \quad (7)$$

Les équations 1, 2 et 4 nous permettent donc de définir de manière unique une caractéristique C(V) pour un empilement dont on a précisé les paramètres caractéristiques : le type de métal ($W_{F,M}$), l'épaisseur du diélectrique (son épaisseur $T_{ox}$ ou l'EOT) et le type de semi-conducteur (son travail de sortie $W_{F,S}$ et sa relation entre charge et potentiel : $\psi_{sc}$ (Qsc)). Si on utilise Vfb plutôt que $W_{F,S}$, Vfb, EOT et $\psi_{sc}$ (Qsc) définissent alors de manière unique la caractéristique C(V) à partir des équations 1,2 et 5. Toutefois, on notera que ces équations sont liées entre elles de manière complexe et qu'il n'est plus possible d'extraire EOT et Vfb de manière indépendante comme ce pouvait être le cas avec les méthodes analytiques.

La figure 4a montre un empilement MOS sur SOI et la figure 4b montre un transistor de type MOS sur SOI. Dans le cas des dispositifs MOS sur SOI, la tension Vfb ne peut plus être identifiée directement par la mesure. En effet, comme il est visible sur les figures 5a et 5b, les caractéristiques C(V) mesurées dans les deux cas apparaissent différentes.

Dans le cas d'un transistor MOS sur substrat massif, la figure 5a montre que pour des tensions de grille Vg différentes la capacité varie, ce qui reflète une variation de charge dans le substrat semi-conducteur SUB. En particulier pour des tensions de grilles Vg négatives le substrat SUB est en inversion de trous. A l'augmenter de la tension de grille Vg les électrons dans le substrat SUB augmentent jusqu'à l'obtention d'une accumulation d'électrons. En allant de l'inversion de trous à l'accumulation d'électrons, le substrat SUB passe forcément par une condition de charge nulle. Autrement dit, la remontée de la capacité pour des tensions de grille Vg positives permet d'identifier la condition de bandes plates Vfb.

La situation de la figure 5b est différente. En effet dans le cas d'un empilement MOS sur SOI on n'observe pas de remontée de la capacité aux tensions Vg positives et la tension Vfb ne peut plus être identifiée par la mesure puisque l'on accède plus qu'à la partie inversion de la capacité. Autrement dit, on n'observe plus la remontée de Cgb due à la formation de porteurs majoritaires dans le substrat SUB. Cette différence s'explique par le fait que nous ne disposons pas de diffusion permettant de « lire » la réponse des porteurs majoritaires à l'interface du diélectrique, l'oxyde enterré DGAR se trouvant entre la prise du substrat SUB et la surface du canal Ch, comme il est illustré à la figure 4b.

L'impossibilité d'accéder à Vfb dans le cas d'un empilement MOS sur SOI rend les techniques usuelles de détermination des paramètres Weff et EOT à partir de la caractéristique C(V) particulièrement complexes et parfois peu fiables.

Par exemple, comme il est visible sur la figure 6, il est possible de trouver plusieurs travaux de sortie selon les valeurs que l'on suppose pour des paramètres spécifiques d'un empilement MOS sur SOI : l'épaisseur du film semi-conducteur Ch et de l'oxyde enterré DGAR.

La présente invention propose donc une nouvelle méthode pour la détermination fiable de paramètres tels que Weff et EOT dans le cas d'un empilement MOS sur SOI.

A défaut d'accéder à la réponse des porteurs majoritaires dans le canal Ch pour identifier la condition de bandes plates, le principe de l'invention repose sur la mise en œuvre de mesures qui permettent de connaitre la charge dans le substrat SUB en dessous de l'oxyde enterré DGAR de la structure SOI. Cela permet de bien connaitre l'état global de polarisation du dispositif sur substrat SOI au moins dans les conditions d'inversion de porteurs ou de déplétion du canal Ch.

Si la mesure de la charge d'inversion du canal Ch est bien connue de l'homme de l'art et correspond à l'intégrale de la capacité Cgc, la mesure de la charge du substrat SUB n'est pas courante en MOS sur SOI et il n'existe pas de moyen immédiat pour y accéder.

Rappelons que, sur la base de l'équation (2), la charge dans un semi-conducteur est calculée à partir de l'intégrale de la capacité. Pour effectuer ce calcul il est nécessaire de connaître la condition de bandes plates qui correspond à une charge nulle. A la différence de la mesure de Cgb sur substrat massif qui connait toute une variation d'amplitude permettant d'identifier la condition de bandes plates et donc d'identifier la charge en fonction de la polarisation, la mesure de Cgb sur SOI rencontre au moins deux difficultés. Visiblement, cette capacité est d'abord nulle puis après son apparition au seuil d'extinction de la capacité Cgc, elle est ensuite quasi constante dans sa plus grande partie. Ceci est illustré à la figure 7 qui montre les contributions de Cgb et Cgc à la capacité totale mesurée pour un MOS sur SOI. Là où Cgb est nulle, la charge dans le substrat SUB n'est pas nécessairement nulle, mais la capacité Cgb devient nulle car c'est la réponse des porteurs du canal Ch, visible sur la capacité Cgc, qui masque l'influence électrostatique dans le substrat des fluctuations appliquées depuis la grille face avant GAV. On peut donc résumer en disant que quand Cgc devient nulle cela correspond bien à une annulation de la charge de porteurs libres et que Cgc(Vgs) permet donc d'identifier la charge de canal en fonction de la polarisation Vgs. Par contre la mesure de Cgb manque de référence car l'annulation de Cgb ne signifie pas que la charge de substrat SUB s'annule, mais qu'elle ne varie plus. On manque donc sur cette caractéristique d'une tension de référence pour laquelle la charge de substrat SUB serait nulle et à partir de laquelle on peut calculer une intégrale du type de l'équation (2) pour le calcul de la charge de substrat.

Le principe de l'invention consiste à mesurer une famille de caractéristiques $C_{gb,Bias}(Vgs ; Vbias)$ en fonction de la tension Vgs appliquée à la grille face avant, chaque caractéristique $C_{gb,Bias}$ étant mesurée pour une tension -Vbias donnée, la tension -Vbias étant appliquée à la fois à la grille face avant GAV et aux deux électrodes source S et drain D.

Les caractéristiques $C_{gb,Bias}(Vgs ; Vbias)$ sont mesurées à l'aide du montage illustré à la figure 8b. Dans un tel montage, il n'est pas possible de rajouter une tension de polarisation sur la grille face arrière, car cette connexion est destinée à l'impédance-mètre illustrée à la figure 2b. En revanche, une tension de polarisation -Vbias est connectée à la fois à la grille face avant GAV et aux électrodes sources S et drain D.

En faisant varier Vbias, on fait varier l'état de charge du canal Ch. Cela contribue à faire varier la plage de tension Vgs pour laquelle le canal Ch se trouve en zone de déplétion et à faire varier la plage de tension Vgb (=Vgs-Vbias) pour laquelle on est en régime de déplétion. Il est donc possible d'accéder à la caractéristique Cgb sur une plus grande plage de valeurs de Vgb, ce qui permet de déterminer la tension de bandes plates Vfb à la face arrière du substrat SUB.

On peut donc mesurer un ensemble de caractéristiques Cgb(Vgs ; Vbias). Chaque caractéristique Cgb(Vgs ; Vbias) est obtenue pour une valeur de Vbias fixée et en faisant varier Vgs.

En balayant une plage suffisamment étendue de valeurs de Vbias, il est possible d'accéder au régime d'inversion du substrat SUB, tout en gardant le canal Ch en déplétion. Autrement dit, en mesurant un nombre suffisamment élevé de caractéristiques Cgb(Vgs ; Vbias) il est possible de remonter à la tension de bandes plates Vfb à la face arrière de l'oxyde enterré DGAR.

La première étape APP du procédé consiste à appliquer un stimulus au transistor MOS sur substrat SOI. Plus précisément le stimulus appliqué sur la grille face avant GAV est constitué par la superposition d'une tension principale continue Vgs et une tension alternative v(t). La tension principale continue Vgs peut balayer une plage de valeurs prédéterminée.

Cette mesure conduit à deux nouvelles capacités que l'on nomme Cbc (respectivement Cgb) pour le couplage entre la grille face avant GAV et le canal Ch (respectivement le couplage entre la grille face avant GAV et la grille face arrière GAR.

La deuxième étape BIAS du procédé consiste à appliquer une tension - Vbias à la fois à la grille face avant GAV et aux électrodes source S et drain D.

La troisième étape MIG consiste à mesurer, pour une valeur de la tension -Vbias donnée, le courant électrique Ig(t) issu de la grille face arrière en fonction de Vgs et déterminer à partir de cette mesure la capacité C entre la grille face avant et la face arrière du substrat du transistor, de façon à obtenir la caractéristique $C_{gb,Bias}(Vgs ; Vbias)$.

On notera cette fois que la capacité Cgb (Vgs ; Vbias) qui correspond à la mesure et qui retient notre attention connait sur la plage de tension Vgs, à partir du moment où la capacité Cgc devient nulle, tout d'abord une augmentation significative, puis ensuite une relative stagnation, comme il est illustré à la figure 9. Le procédé selon l'invention permet d'accéder à une plage de valeurs de Vgb grâce à l'acquisition de plusieurs caractéristiques à des tensions Vbias différentes.

A cette fin, la quatrième étape MIG_BIAS du procédé consiste à faire varier la valeur de la tension -Vbias et déterminer une multiplicité de caractéristiques $C_{gb,Bias}(Vgs ; Vbias)$, chaque caractéristique correspondant à une valeur de - Vbias.

La détermination de chaque caractéristique $C_{gb,Bias}(Vgs ; Vbias)$ se fait en mesurant le courant Ig(t) comme il a été expliqué en référence à l'étape MIG.

Lors de cette étape il est possible d'obtenir un ensemble de caractéristiques tel que celui illustré à la figure 9.

Autrement dit, chacune des caractéristiques $C_{gb,Bias}$(Vgs ; Vbias) est obtenue en fixant une valeur de Vbias et en balayant la tension Vgs appliquée à la grille face avant.

Avantageusement, la variation de Vgs et de Vbias permet de mesurer plusieurs caractéristiques $C_{gb,Bias}$ dans différentes conditions de charge dans le substrat SUB et dans le canal Ch, y compris la condition de déplétion du canal Ch. La condition de déplétion du canal Ch est nécessaire pour éviter que les charges dans le canal masquent la réponse due à la capacité Cgb.

La cinquième étape CARAC du procédé consiste à transformer l'ensemble de caractéristiques Cgb(Vgs) en un ensemble de caractéristiques Cgb(Vgb) illustré à la figure 10. Vgb est la chute de potentiel entre la grille face avant GAV et la face arrière GAR du substrat semi-conducteur SUB. Autrement dit, Vgb peut être calculée comme Vgb = Vgs - Vbias.

Cette étape permet d'obtenir un ensemble caractéristiques Cbg(Vgb ; Vbias) qui reflète directement le couplage entre la grille face avant GAV et la grille face arrière GAR.

La sixième étape ENV du procédé permet d'obtenir la caractéristique $C_{gb,Bias}$(Vgb). Cette caractéristique $C_{gb,Bias}$(Vgb) est obtenue en calculant l'enveloppe de l'ensemble de caractéristiques illustré à la figure 10.

Par exemple, une méthode simple de calcul de l'enveloppe $C_{gb,Bias}$(Vgb) consiste à ne conserver des caractéristiques Cgb qu'une plage de 1 Volt à partir des tensions ou les caractéristiques commencent à saturer autour de leurs valeurs maximales.

Avantageusement, comme il est visible sur la figure 10, l'enveloppe des caractéristiques Cgb(Vgb) reconstitue une courbe C(V) typique d'un empilement MOS sur substrat massif.

La zone où la caractéristique Cgb(Vgb) reproduit la caractéristique C(V) d'un MOS sur substrat massif correspond à la condition de déplétion du canal semi-conducteur Ch. Cette plage significative est donc délimitée d'un côté par la limite de l'inversion des trous qui cause une augmentation abrupte de Cbg aux tensions Vgb négatives et d'un autre côté par l'amorce à une tension Vgb plus positive de la formation d'une accumulation d'électrons dans le canal Ch.

La valeur de cette plage de tension est donnée en première approximation par $Eg(T_{box} + T_{ch,equiv} + T_{ox})/(T_{ch,equiv} + T_{box})$, où Eg est l'énergie de gap du semi-conducteur et $T_{box}$, $T_{ch,equiv}$, $T_{ox}$ sont respectivement les épaisseurs de l'oxyde enterré DGAR, du canal Ch en épaisseur équivalente d'oxyde de silicium et de l'oxyde de grille ou diélectrique de grille avant DGAV. On a $T_{ch,equiv} = T_{ch} \cdot (\varepsilon_{SiO2}/\varepsilon_{ch})$.

Avantageusement, cette étape du procédé permet d'extraire une caractéristique Cgb(Vgb) qui est celle d'un empilement MOS sur substrat massif où :

- la grille face avant GAV est toujours la grille GAV de la capacité étudiée ;
- l'oxyde correspond à l'empilement de trois couches diélectriques qui sont respectivement l'oxyde de grille face avant DGAV, le canal Ch déplété et qui se comporte comme un diélectrique et l'oxyde enterré DGAR ;
- le semi-conducteur est le substrat SUB à la face arrière de l'oxyde enterré.

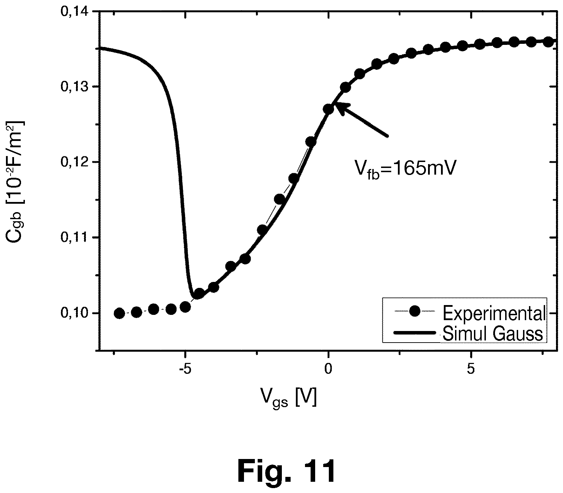

La figure 11 illustre l'étape d'ajustement entre la caractéristique enveloppe $C_{gb,Bias}$(Vgb) et un modèle théorique pour la caractéristique C(V) d'un empilement MOS sur substrat massif.

Cette étape permet d'extraire les paramètres de l'empilement MOS équivalent. Cet ajustement doit nécessairement se faire en retenant pour la caractéristique C(V) la plage de valeurs de tension Vgs appliquée pour laquelle le canal Ch est en régime de déplétion, de sorte à ne pas masquer la réponse des porteurs dans le substrat SUB.

Par exemple le modèle théorique utilisé pour l'empilement MOS est une simulation qui prend en compte les propriétés quantiques de l'empilement.

Par exemple les paramètres extraits peuvent être la tension de bandes plates Vfb à la face arrière de l'oxyde enterré DGAR, le travail de sortie de l'électrode de grille face avant Weff et l'épaisseur d'oxyde équivalent EOT.

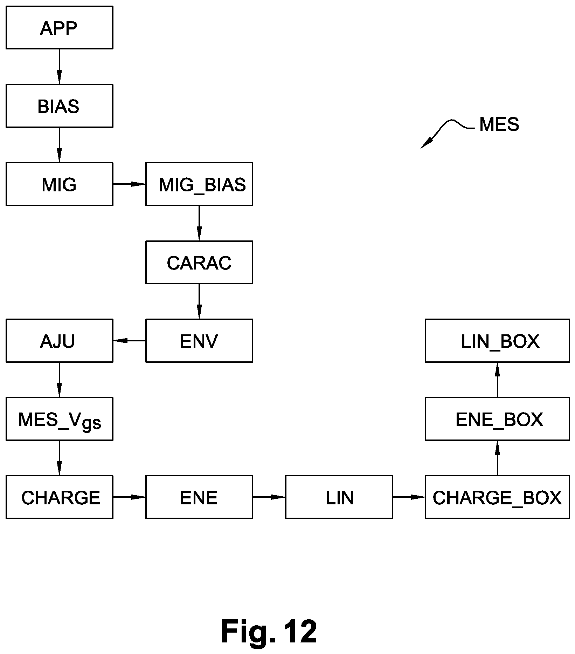

Dans l'exemple de figure 12 les paramètres obtenus sont Vfb = 0.165 V, Weff = 4.47 eV et $EOT = T_{box} + T_{ch,equiv} + T_{ox}$ = 24.8 nm.

Le procédé de mesure selon l'invention permet donc une extraction de Weff et de $EOT = T_{box} + T_{ch,equiv} + T_{ox}$ grâce au fait que les mesures sur MOS sur SOI sont ramenées au comportement d'un MOS sur substrat massif.

Le procédé selon l'invention peut également comporter une ou plusieurs des caractéristiques suivantes selon toutes les combinaisons techniquement possibles :

- le jeu de paramètres PAR comprend, en plus de la tension de bandes plates Vfb à la face arrière de l'oxyde enterré, au moins l'un des paramètres suivants :

  - l'épaisseur équivalente d'oxyde EOT ;

  - le travail de sortie effectif du métal de grille Weff ;

- l'épaisseur équivalent d'oxyde (EOT) correspond à l'épaisseur cumulée des couches d'oxyde, de canal et d'oxyde enterré.
- L'ensemble de caractéristiques Cgb(Vgs ; Vbias) comprend au moins dix caractéristiques obtenues pour dix valeurs de Vbias différentes ;
- lors de l'étape d'application de la tension -Vbias à la grille face avant GAV et aux électrodes source S et drain D et de l'étape de mesure de l'ensemble de caractéristiques $C_{gb,Bias}$(Vbs ; Vbias), la tension Vbias est montée progressivement sur les deux connexions, grille face avant GAV et électrodes source S et drain D ;
- La variation de tension Vbias est faite alternativement sur les deux connexions et par paliers ;
- La variation de tension Vbias à chaque palier est comprise entre 0,05 et 0,5 V ;
- le procédé selon l'invention comprend en outre les étapes suivantes :

  - à partir d'une mesure de type C(Vgs) déterminer les caractéristiques Cgc(Vgs) et Cgb(Vgs), Vgs étant la tension appliquée entre la grille face avant GAV et les électrodes source S et drain D du transistor MOS sur substrat SOI ;

  - à partir de la valeur de la tension de bandes plates Vfb déterminée à l'étape d'ajustement et des caractéristiques Cgb(Vgs) et Cgc(Vgs), calculer la densité surfacique de porteurs N(Qtot) en fonction de la tension Vgs ;

  - à partir de la densité surfacique de porteurs N(Qtot), déterminer l'énergie E, définie par la relation E= qVgs + X + (Ec-Ef), en fonction du nombre de porteurs Ntot, q étant la charge de l'électron, X l'affinité électronique du semiconducteur du canal, Ef le niveau de Fermi du semi-conducteur de canal, Ec l'énergie de la bande de conduction du semi-conducteur du canal à son interface avec l'oxyde de grille face avant DGAV ;

  - obtenir à l'aide d'un ajustement linéaire de E en fonction du nombre de porteurs le travail de sortie effectif Weff de la grille avant et l'épaisseur EOTfox effectif de l'oxyde de grille face avant DGAV ;

- le travail effectif de sortie Weff est l'ordonnée à l'origine de la fonction E(Ntot) et l'épaisseur effective de l'oxyde de grille avant EOTfox est obtenue à partir de la pente de la fonction E(Ntot).

## LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- La figure 1a montre un schéma d'un empilement MOS, métal/oxyde/semi-conducteur ;
- La figure 1b montre un exemple de transistor MOS obtenu à partir de l'empilement de la figure 1a et ayant un substrat de type N ;
- La figure 2a montre la capacité mesurée entre grille face avant GAV et la face arrière GAR du substrat semi-conducteur pour un transistor du type montré en figure 1b, le substrat étant de type P ;
- La figure 2b montre un montage pour la mesure de la capacité de figure 2a à l'aide d'un impédance-mètre ;
- La figure 3a montre en détail le montage pour la mesure de la capacité Cgc entre grille face avant GAV et canal Ch à l'aide de l'impédance-mètre de figure 2b, dans le cas d'un transistor MOS sur substrat massif ;
- La figure 3b montre en détail le montage pour la mesure de la capacité Cgb entre grille face avant GAV et prise substrat face arrière PSAR à l'aide de l'impédance-mètre de figure 2b, dans le cas d'un transistor MOS sur substrat massif ;
- La figure 4a montre un schéma d'un empilement MOS, métal/oxyde/semi-conducteur, sur SOI, silicon on insulator ;
- La figure 4b montre un transistor MOS sur SOI ;
- La figure 4c montre le montage expérimental pour la mesure de la capacité Cgc dans le cas d'un MOS sur SOI ;
- La figure 4d montre le montage expérimental pour la mesure de la capacité Cgb dans le cas d'un MOS sur SOI ;
- La figure 5a montre la caractéristique C(Vg) pour un transistor MOS sur substrat massif, le transistor ayant un substrat de type N et des diffusions source et drain de type P, Vg étant la tension de grille face avant ;
- La figure 5b montre une caractéristique C(Vg) pour un transistor MOS sur SOI ayant des diffusions source et drain de type P, Vg étant la tension de grille face avant GAV;
- La figure 6 montre différents ajustements d'une caractéristique Cgc pour un transistor MOS sur SOI ;
- La figure 7 montre les capacités Cgc et Cgb obtenues pour un MOS sur substrat SOI ; ces mesures sont obtenues avec les montages des figures 4c et 4d ;
- Les figures 7a et 7b montrent différentes caractéristiques Cgc(Vg) obtenues pour un même empilement metal/oxyde/semi-conducteur sur SOI et différentes polarisation Vb de grille face arrière GAR ou différents types de dopage de substrat face arrière ;

- La figure 8a montre le montage pour la mesure de la capacité $C_{gc,Bias}$ selon l'invention entre grille face avant GAR et substrat SUB ;
- La figure 8b montre le montage selon l'invention pour la mesure de la capacité $C_{gb,Bias}$ selon l'invention entre grille face avant GAR et canal Ch ;
- La figure 9 montre un ensemble de caractéristiques $C_{gb,Bias}$ (Vgs ; Vbias), chaque caractéristique étant fonction de la tension Vgs et étant obtenue pour une valeur de Vbias donnée ;
- La figure 10 montre les capacités $C_{gb,Bias}$ (Vgs ; Vbias) de la figure 9 tracées cette fois en fonction de Vgb, à savoir $C_{gb,Bias}$ (Vgb ; Vbias) ;
- La figure 11 montre l'ajustement entre la capacité enveloppe $C_{gb,Bias}$(Vgb) et un modèle théorique pour un transistor MOS sur substrat massif, la caractéristique $C_{gb,Bias}$(Vgb) étant l'enveloppe des caractéristiques $C_{gb,Bias}$ (Vgb ; Vbias) illustrées à la figure 10 ;
- La figure 12 montre un schéma des étapes du procédé selon l'invention ;
- La figure 13 montre comment, grâce à l'ajustement de la figure 11, on peut identifier la tension de bandes plates Vfb à la face arrière de l'oxyde enterré DGAR pour les mesures de la figure 7 ;
- La figure 14 montre les différentes densités surfaciques de charge obtenue à partir des mesures de la figure 13 ;
- La figure 15 montre les courbes de densité surfacique totale de la figure 14 pour différentes valeurs de polarisation Vb de grille face arrière GAR ;
- La figure 16 montre des simulations de la densité surfacique de charge totale en fonction de la différence Ef-Ec pour différents transistors MOS sur substrat massif et MOS sur SOI ;
- La figure 17 montre la relation universelle N(Qtot) = f(Ef-Ec) pour un substrat Silicium en régime d'accumulation ou d'inversion de porteurs libres ;
- La figure 18 montre l'énergie E = qVgs + X + (Ec-Ef), obtenue grâce aux courbes des figures 17 et 15, en fonction de la densité totale de porteurs Ntot ;
- La figure 19 représente les valeurs des courbes de la figure 17 sous forme de tableau.

## DESCRIPTION DETAILLEE

La figure 12 montre un schéma des étapes du procédé MES de mesure d'un jeu de paramètres PAR d'un transistor de type MOS sur SOI.

Le jeu de paramètres déterminé comprend au moins la tension de bande plates Vfb à la face arrière de l'oxyde enterré DGAR.

Selon un mode de réalisation, le jeu de paramètres ainsi déterminé comprend également des paramètres tels que l'épaisseur d'oxyde équivalent EOT et le travail de sortie effectif Weff du métal de la grille face avant GAV.

La première étape APP comprend l'application d'un stimulus à la grille face avant du transistor MOS sur SOI. Ce stimulus est formé par une tension principale continue Vgs et une tension alternative v(t).

La tension principale Vgs peut balayer une plage de tensions DV.

La deuxième étape BIAS du procédé consiste à appliquer une tension - Vbias à la fois à la grille face avant GAV et aux électrodes source S et drain D.

Avantageusement, cette étape permet de faire varier la plage de tension Vgb sur laquelle la condition de canal déplété est obtenue.

Selon un mode de réalisation de l'étape BIAS, la tension -Vbias est appliquée progressivement sur les deux connexions, respectivement grille face avant GAV et les électrodes source S et drain D.

Selon un mode de réalisation de l'étape BIAS, la variation de tension Vbias est faite alternativement sur les deux connexions et par paliers jusqu'à obtention de la valeur visée.

Selon un mode de réalisation, la variation de tension Vbias à chaque palier est comprise entre 0,05 et 0,5 V.

Avantageusement, la montée progressive de Vbias permet d'éviter une dégradation irrémédiable de l'oxyde O entre grille face avant et source et drain. Sans ces précautions une telle dégradation serait possible, d'autant plus que la tension Vbias peut atteindre des valeurs élevées et que son application n'est pas nécessairement simultanée sur les deux connexions.

La troisième étape MIG du procédé comprend la mesure du courant Ig(t) issu de la grille face arrière GAR du transistor MOS sur SOI. La troisième étape MIG comprend également la mesure, à partir de la mesure du courant Ig(t), de la capacité $C_{gb,Bias}$(Vgs ; Vbias) entre la grille face avant GAV et la face arrière du substrat SUB. Cette capacité $C_{gb,Bias}$(Vgs ; Vbias) correspond à une des courbes représentées à la figure 9 et elle est obtenue pour une valeur de la tension -Vbias donnée.

La première étape APP, la deuxième étape BIAS, et la troisième étape MIG du procédé MES selon l'invention peuvent être réalisées grâce au montage illustré à la figure 8b. Sur la figure 8b on peut voir que la tension Vgs, la tension v(t) et la tension -Vbias sont appliquées à la grille face avant GAV du transistor MOS sur SOI.

Avantageusement, la superposition d'une tension continue Vgs et d'une tension alternative v(t) permet de mesurer la capacité entre la grille face avant GAV et la face arrière GAR du substrat SUB du semi-conducteur. La mesure de la capacité peut être réalisée en analysant le courant Ig(t) à l'aide d'un impédance-mètre comme il est montré à la figure 2b.

La quatrième étape MIG_BIAS du procédé consiste à faire varier la valeur de la tension -Vbias et déterminer une multiplicité de caractéristiques $C_{gb,Bias}$(Vgs ; Vbias), chaque caractéristique correspondant à une valeur de -Vbias.

Lors de cette étape il est possible d'obtenir une multiplicité de caractéristiques telle que celle illustrée à la figure 9. Autrement dit, chacune des caractéristiques $C_{gb,Bias}$(Vgs ; Vbias) est obtenue en fixant une valeur de Vbias et en balayant la tension Vgs appliquée à la grille face avant.

Grâce au montage illustré à la figure 8a, il est possible de mesurer la capacité Cgc entre face avant GAV du substrat SUB et canal Ch du transistor MOS sur SOI.

Le procédé de mesure MES selon l'invention comprend en outre une étape de détermination CARAC de la multiplicité de caractéristiques $C_{gb,Bias}$(Vgb ; Vbias), Vgb étant la chute de potentiel entre grille face avant GAV et face arrière GAR du substrat SUB.

Avantageusement, l'ensemble de caractéristiques $C_{gb,Bias}$(Vgb ; Vbias) permet de rendre compte du couplage entre grille face avant GAV et grille face arrière GAR.

Cette étape correspond à un changement de variable, car Vgb peut être exprimée comme Vgb = Vgs - Vbias, comme il est visible sur la figure 8b.

Le résultat de cette étape CARAC d'obtention de l'ensemble des caractéristiques $C_{gb,Bias}$(Vgb ; Vbias) à partir de l'ensemble des caractéristiques $C_{bg,Bias}$(Vgs ; Vbias) est représenté à la figure 10. Chacune des courbes de figure 10 est obtenue pour une valeur de Vbias différente.

Avantageusement, chacune des courbes $C_{gb,Bias}$(Vgb ; Vbias) de la figure 11 est assimilable à une partie de la caractéristique Cgb(Vgb) obtenue pour un transistor MOS sur substrat massif.

Selon un mode de réalisation de l'invention au moins 10 caractéristiques $C_{gb,Bias}$(Vgb ; Vbias) sont mesurées, chaque caractéristique étant réalisée pour une valeur différente de Vbias.

Avantageusement, la superposition de plusieurs caractéristiques Cgb telle que celle montrée à la figure 11 permet d'obtenir une mesure de capacité assimilable à celle d'un transistor MOS sur substrat massif sur une plage étendue de valeurs de Vgb.

En effet lors de l'étape ENV, la caractéristique $C_{gb,Bias}$(Vgb) est calculée, cette caractéristique étant l'enveloppe supérieur de l'ensemble de caractéristiques $C_{gb,Bias}$(Vgb ; Vbias).

Avantageusement la caractéristique enveloppe $C_{gb,Bias}$(Vgb) est assimilable à la caractéristique Cgb(Vgb) d'un transistor MOS sur substrat massif. Autrement dit, la remontée visible sur la caractéristique $C_{gb,Bias}$(Vgb) permet de déduire la tension de bandes plates à la face arrière de l'oxyde enterré DGAR.

Le procédé de mesure MES selon l'invention comprend une quatrième étape AJU de détermination du jeu de paramètres PAR du transistor MOS sur SOI. Cette étape est réalisée à l'aide d'un ajustement entre la caractéristique $C_{bg,Bias}$(Vgb) et un modèle théorique décrivant le comportement d'un transistor de type MOS sur substrat massif.

Un tel ajustement est montré par exemple à la figure 11. Cet ajustement est limité à la plage de valeurs de Vgb pour lesquels le canal Ch du transistor est en régime de déplétion.

En effet quand le canal Ch est en régime de déplétion, la couche de semi-conducteur se comporte comme un diélectrique. Le comportement du transistor MOS sur SOI est assimilable au comportement d'un transistor MOS sur substrat massif dans lequel l'oxyde O est formé par l'empilement de l'oxyde de grille face avant DGAV, le canal semi-conducteur en régime de déplétion Ch et l'oxyde enterré DGAR.

Grâce au procédé de mesure MES selon l'invention il est possible d'accéder à la caractéristique $C_{gb,Bias}$(Vgb) sur une grande plage de valeurs de la tension Vgb, cette plage comprenant la zone d'inversion de charge du substrat et permettant la détermination de la tension de bandes plates Vfb à la face arrière de l'oxyde enterré DGAR. En particulier, grâce à l'application de la tension -Vbias il est possible de contrôler la charge dans le canal Ch de sorte à garder le canal en déplétion et pouvoir accéder à la caractéristique $C_{gb,Bias}$(Vgb) à partir de la famille de caractéristiques mesurées $C_{gb,Bias}$(Vgb ; Vbias).

Le modèle théorique utilisé pour l'ajustement peut donc être un modèle de transistor MOS sur substrat massif connu de l'homme du métier. Par exemple une simulation prenant en compte des effets quantiques peut être utilisée.

Par exemple, dans le cas de l'ajustement de la figure 12 les paramètres suivants sont obtenus Vfb = 0.165 V, EOT = 24.8 nm Weff = 4.47 eV.

L'EOT extrait avec le procédé MES selon l'invention est donc une estimation de l'épaisseur de l'empilement formé par la couche d'oxyde face avant DGAV d'épaisseur $T_{ox}$, la couche semi-conductrice Ch en régime de déplétion d'épaisseur $T_{ch,equiv}$ et l'oxyde enterré DGAR, d'épaisseur $T_{box}$.

Avantageusement, le procédé MES selon l'invention permet d'interpréter le comportement complexe du transistor MOS sur substrat SOI en utilisant la connaissance du comportement d'un transistor MOS sur substrat massif.

La connaissance de la tension de bande plates Vfb à la face arrière de l'oxyde enterré DGAR permet d'identifier la condition de tension appliquée pour laquelle la charge dans le substrat SUB semi-conducteur est nulle. Il est donc possible de calculer, à partir de cette condition de charge nulle la charge pour d'autres polarisations de substrats pourvu que l'on reste en déplétion.

A cette fin, le procédé MES selon l'invention comprend en outre une étape MES_Vgs de mesure des capacités Cgc et Cgb en fonction de la tension Vgs.

Cette étape du procédé MES est réalisée à l'aide des montages des figures 4c et 4d. La tension Vgs est la tension appliquée entre la grille face avant GAV et les électrodes sources S et drain D du semi-conducteur MOS sur substrat SOI. La capacité Cgc est la capacité entre la grille face avant GAV et le canal semi-conducteur Ch. La capacité Cgb est la capacité entre la grille face avant GAV et la face arrière GAR du substrat semi-conducteur SUB.

En d'autres termes, les capacités Cgc et Cgb mesurées à l'étape MES_Vgs sont les capacités mesurées de façon connue par l'homme du métier. Ces mesures sont représentées à la figure 7. Sur cette figure on peut voir que la capacité Cgb ne remonte pas aux tensions positives, à cause du fait que la présence de l'oxyde enterré DGAR empêche l'arrivée des porteurs majoritaires. Il est donc impossible d'accéder à la tension de bandes plates Vfb à partir de ces mesures.

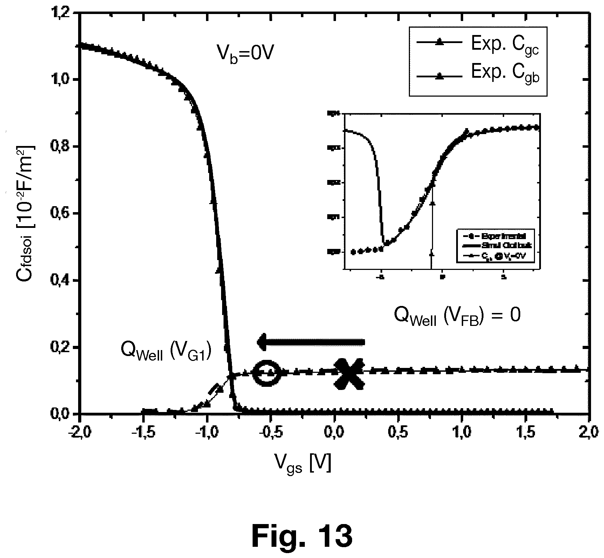

Cependant, grâce à la tension de bandes plates Vfb à la face arrière de l'oxyde enterré DGAR, déterminée à l'étape AJU du procédé MES selon l'invention, il est possible de revenir pertinemment sur les mesures de figure 7 et de calculer pour chaque tension Vgs la charge du canal Ch d'une part et du substrat SUB d'autre part. La figure 13 montre les mesures de figure 7 et la tension de bandes plates Vfb indiquée avec un x sur la courbe Cgb.

Le procédé MES selon l'invention comprend donc une étape CHARGE de calcul de la densité surfacique de porteurs N(Qtot) en fonction de la tension Vgs.

La densité surfacique de porteurs peut être calculée à partir de la charge en utilisant l'équation suivante

$$Q = q \, N(Q) \quad (8)$$

avec q la charge élémentaire de l'électron

On entend ici par Qtot la charge totale qui est la somme des charges de porteurs libres et charges fixes :

$$Q_{tot} = Q_{Ch} + Q_{Well} + Q_{dop,ch} + Q_{box} + Q_{int} \quad (9)$$

Dans l'équation (9) on retrouve les contributions des charges du canal Ch, $Q_{Ch}$, du substrat SUB semi-conducteur, $Q_{Well}$, des dopants du canal déplété, $Q_{dop,ch}$, des charges fixes de l'oxyde enterré DGAR, $Q_{box}$, et les charges fixes à l'interface entre l'oxyde face avant DGAV et le canal Ch, $Q_{int}$.

Cette équation peut être simplifiée en prenant en compte uniquement les charges du canal Ch et celles du substrat SUB semi-conducteur :

$$Q_{tot} = Q_{Ch} + Q_{Well} \quad (9b)$$

Ce calcul des charges dans les différentes couches semi-conductrices canal Ch et substrat SUB peut alors être réalisé à l'aide de l'équation (2). L'intégrale d'une capacité C en F/m$^2$ conduit sur le mode d'une équation du type de l'équation (2) à une charge Q en C/m$^2$.

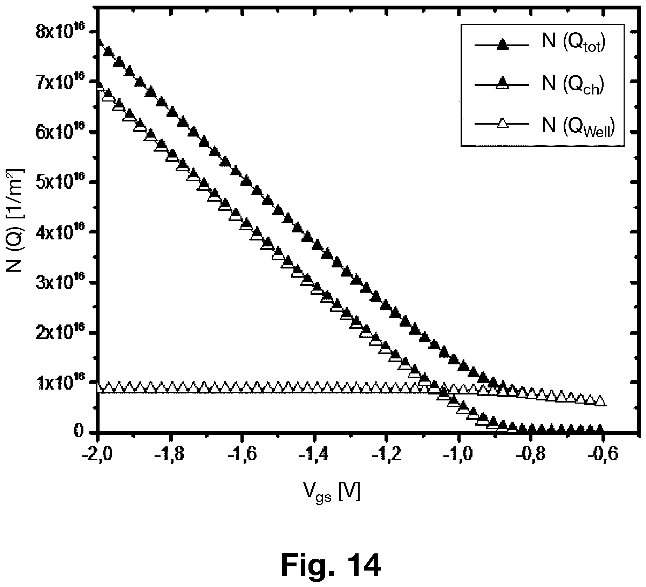

La figure 14 montre la densité surfacique de porteurs totale N(Qtot), la densité surfacique de porteurs dans le canal Ch N(Qch) et la densité surfacique de porteurs dans le substrat semi-conducteur SUB N(QWell). Ces densités surfaciques sont obtenues à l'étape CHARGE du procédé MES selon l'invention.

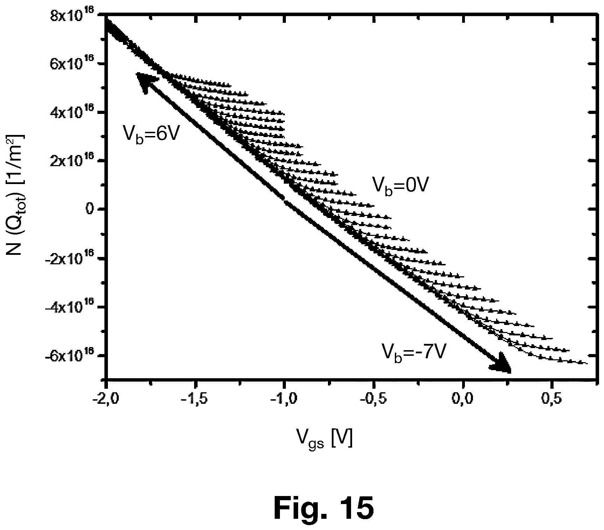

La figure 15 montre la densité surfacique de porteurs N(Qtot) pour différentes polarisations de face arrière Vb. Les courbes de la figure 15 sont obtenues pour des polarisations de face arrière Vb comprises entre 6 V et -7 V.

Remarquablement, en dehors du régime de déplétion, c'est-à-dire dès que l'on a une inversion dans le canal Ch, les différentes courbes se superposent. Ce qui semble témoigner d'un comportement général du semi-conducteur. Etant donné que c'est une relation qui lie Vgs et Qtot et compte tenu de la relation entre ces deux paramètres telle qu'elle est définie en équation 4, il s'agit d'une relation entre la chute de tension dans le semi-conducteur et la charge à son interface.

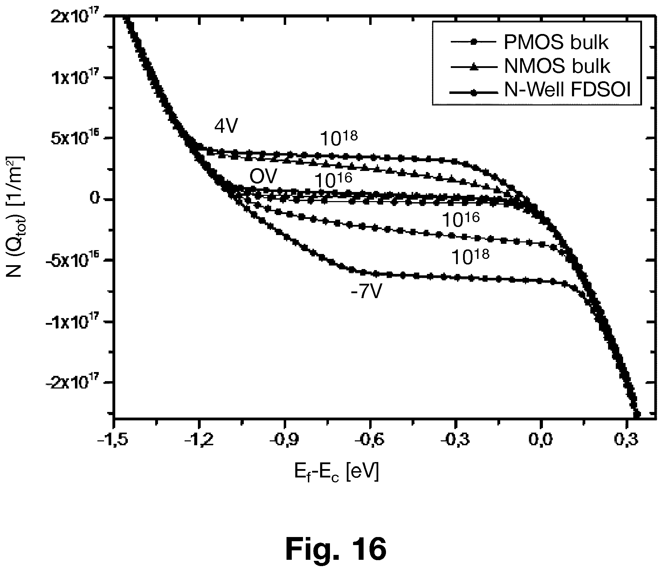

Il est donc possible d'effectuer différentes simulations où on cherche à résoudre pour l'empilement Métal/oxyde/semi-conducteur/oxyde enterré/substrat le potentiel interne selon les polarisations appliquées, par exemple en couplant de manière auto consistante les équations de Poisson et de Schrödinger. Ces simulations ont été effectuées pour différents dispositifs, en cherchant à chaque fois à identifier la relation existant entre la charge totale Qtot vue depuis l'interface entre DGAV et Ch et la position relative du niveau de Fermi Ef et de la bande de conduction Ec du semi-conducteur à cette même interface où on accumule ou inverse les porteurs. Cette étude a été faite pour des capacités sur substrat SOI avec différents niveaux de dopage dans le canal Ch et des capacités sur substrat massif avec différents niveaux de dopage. Ces simulations sont représentées à la figure 16. Plus précisément les courbes de la figure 16 montrent la densité surfacique de porteurs N(Qtot) en fonction de Ef-Ec. Les différentes courbes représentent : des simulations pour des transistors MOS sur SOI pour différentes polarisation Vb de face arrière GAR et des simulations pour des transistors MOS sur substrat massif pour différents dopages du semi-conducteur.

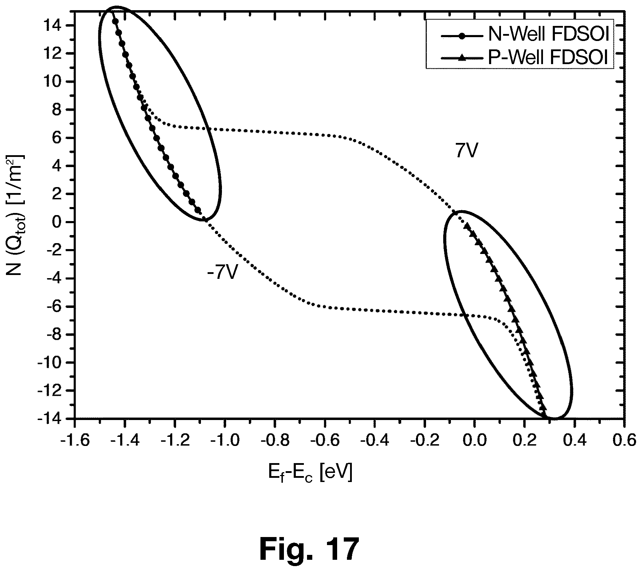

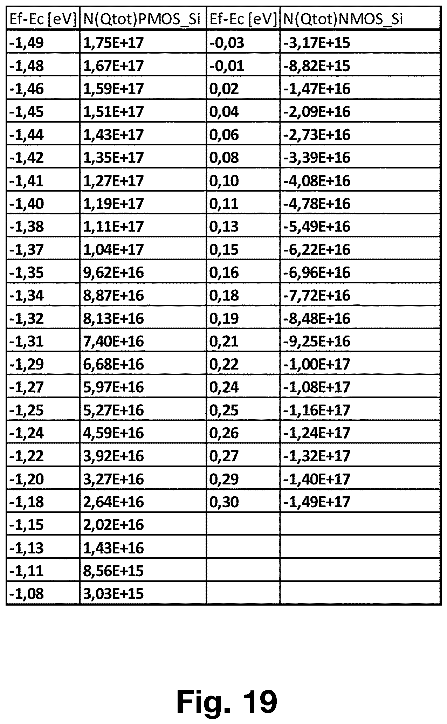

Remarquablement, dès lors qu'on attend l'accumulation ou l'inversion de porteurs libres, on rejoint un comportement universel qui dépend seulement de la nature du semi-conducteur que l'on simule (Silicium, Germanium, GaN,...). La figure 17 montre les caractéristiques N(Qtot) en fonction de Ef-Ec qui peuvent être déduites de ces simulations pour du Silicium. Ces courbes représentent donc la relation entre la densité surfacique de porteurs N(Qtot) et la différence Ef-Ec pour un transistor MOS sur SOI. En particulier, la partie des courbes de la figure 17 signalée en gras et dont les valeurs sont rapportées dans la Figure 19 représente un comportement universel et commun à tout MOS.

Reconsidérant l'équation (3) et prenant en compte que $W_{F,M}/q$= Weff, $W_{F,S}/q$- $\psi_{sc}$ = X + (Ec-Ef)/q et Vox= -q.N(Qtot)/Cox, on arrive à la relation suivante :

$$q.Vgs+ X +(Ec-Ef)= Weff - q. Qtot/Cox \quad (10),$$

dans laquelle X est l'affinité électronique du Semi-conducteur de référence que l'on prend à 4.2 eV pour le Silicium dans cette application. On s'attend donc à ce que le tracé de q.Vgs+ X + (Ec-Ef) en fonction de Qtot conduise à une partie linéaire dont la pente est proportionnelle à l'EOTfox, l'épaisseur effectif de l'oxyde de grille face avant DGAV, et l'ordonnée à l'origine à Weff soit le travail de sortie effectif. En effet, on a Cox= $\varepsilon 0.\varepsilon Sio2$/EOTfox dans l'équation 10 par définition.

Le procédé MES selon l'invention comprend donc une étape ENE de détermination de l'énergie E = q Vgs + X + (Ec-Ef) à partir de la densité surfacique de porteurs N(Qtot). La densité surfacique des porteurs N(Qtot) est liée à la différence Ec-Ef à travers les simulations de la figure 17 et à l'énergie q Vgs à travers les courbes de la figure 14.

Avantageusement, l'étape ENE permet d'obtenir une dépendance linéaire entre l'énergie E et la densité surfacique de charge Q(Ntot) ou la densité surfacique de charges Ntot.

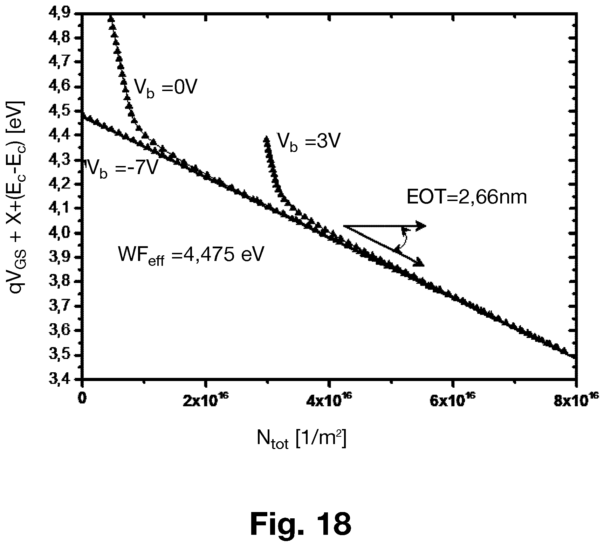

La Figure 18 montre ce type de tracé linéaire pour les données de la Figure 7 en utilisant la relation Qtot(Vgs) montrée à la Figure 15.

Le procédé MES selon l'invention comprend également une étape LIN d'ajustement linéaire de la quantité E en fonction du nombre de porteurs Ntot.

Avantageusement cette étape conduit directement à une estimation de Weff et EOTfox qui dans ce cas valent respectivement 4.475 eV et 2.66nm. Un ajustement linéaire permet en outre une estimation plus simple, fiable et reproductible des paramètres Weff et EOTfox.

En effet Weff est l'ordonnée à l'origine de la courbe de la figure 18 et EOTfox sa pente à un facteur près. La pente de E(Ntot) vaut -.$q^2$.EOTfox/$\varepsilon_{SiO2}$.

Avantageusement, l'étape LIN permet de déduire avec un ajustement très simple deux paramètres fondamentaux tels que le travail de sortie de la grille face avant Weff et l'épaisseur effectif de l'oxyde face avant EOTfox.

Avantageusement, les étapes MES_Vgs, CHARGE, CARAC et AJU permettent, sous certaines conditions d'accumulation ou d'inversion, de mettre en évidence une relation universelle pour un semi-conducteur entre le champ à son interface et la position du niveau de Fermi.

Cette relation universelle est couplée à la relation mesurée de la charge totale vue à l'interface avec la polarisation pour extraire directement le travail de sortie effectif et l'EOTfox. Cette extraction est faite à partir de l'ordonnée à l'origine et de la pente de la ligne droite ainsi obtenue. La charge totale vue à l'interface est calculée à partir de la charge de substrat SUB et de la charge de canal Ch.

## Revendications

1. Procédé (MES) de mesure d'un jeu de paramètres (PAR) d'un transistor de type MOS sur substrat de type SOI (Silicon On Insulator), ledit jeu de paramètres (PAR) incluant au moins la tension de bandes plates (Vfb) à la face arrière de l'oxyde enterré (DGAR), ledit procédé comprenant les étapes suivantes :

   • Appliquer (APP) à la grille face avant (GAV) du transistor une tension principale continue Vgs et une tension alternative v(t), la tension principale continue Vgs pouvant balayer une plage de valeurs prédéterminée ;
   • Appliquer (BIAS) en outre une tension -Vbias à la grille face avant (GAV) et aux électrodes source (S) et drain (D), la tension -Vbias pouvant balayer une plage de valeurs prédéterminée ;

• Pour une valeur de la tension -Vbias donnée, mesurer (MIG) le courant électrique Ig(t) issu de la grille face arrière en fonction de Vgs et déterminer à partir de cette mesure la capacité entre la grille face avant et la face arrière du substrat du transistor, de façon à obtenir la caractéristique $C_{gb,Bias}$(Vgs ; Vbias);

• Faire varier la valeur de la tension -Vbias et pour chaque valeur de Vbias mesurer (MIG_BIAS) la caractéristique $C_{gb,Bias}$(Vgs ; Vbias) en faisant varier Vgs de sorte à obtenir un ensemble de caractéristiques $C_{gb,Bias}$(Vgs ; Vbias), chaque caractéristique correspondant à une valeur de -Vbias différente ;

• A partir de l'ensemble de caractéristiques $C_{gb,Bias}$(Vgs ; Vbias), déterminer (CARAC) l'ensemble de caractéristiques $C_{gb,Bias}$(Vgb ; Vbias), Vgb étant la tension entre la grille face avant et la grille face arrière ;

• Déterminer (ENV) la caractéristique $C_{gb,Bias}$(Vgb), cette caractéristique étant l'enveloppe de l'ensemble de caractéristiques $C_{gb,Bias}$(Vgb ; Vbias) ;

• Déterminer (AJU) le jeu de paramètres en réalisant un ajustement entre la caractéristique $C_{gb,Bias}$(Vgb) et un modèle théorique décrivant le comportement d'un transistor de type MOS sur substrat massif, ledit ajustement étant limité à la plage de valeurs de Vgb pour lesquels le canal du transistor est en régime de déplétion.

2. Procédé (MES) selon la revendication précédente **caractérisé en ce que** le jeu de paramètres (PAR) comprend, en plus de la tension de bandes plates (Vfb) à la face arrière de l'oxyde enterré, au moins l'un des paramètres suivants :

- l'épaisseur équivalente d'oxyde (EOT) ;
- le travail de sortie effectif du métal de grille (Weff).

3. Procédé (MES) selon la revendication précédente **caractérisé en ce que** l'épaisseur équivalent d'oxyde (EOT) correspond à l'épaisseur cumulée des couches d'oxyde, de canal et d'oxyde enterré.

4. Procédé (MES) selon l'une des revendications précédentes **caractérisé en ce que** lors de l'étape d'application (MIG) de la tension -Vbias à la grille face avant GAV et aux électrodes source S et drain D et de l'étape de mesure (MIG_BIAS) de l'ensemble de caractéristiques $C_{gb,Bias}$(Vbs ; Vbias), la tension -Vbias est montée progressivement et par paliers sur les deux connexions, les deux connexions étant respectivement la grille face avant (GAV) et les électrodes source (S) et drain (D).

5. Procédé (MES) selon l'une des revendications précédentes **caractérisé en ce que** la tension Vbias est montée alternativement sur les deux connexions, grille face avant (GAV) et électrodes source (S) et drain (D).

6. Procédé (MES) selon l'une des revendications précédentes **caractérisé en ce qu'**il comprend en outre les étapes suivantes :

- à partir d'une mesure de type C(Vgs) déterminer (MES_Vgs) les caractéristiques Cgc(Vgs) et Cgb(Vgs), Vgs étant la tension appliquée entre la grille face avant (GAV) et les électrodes source (S) et drain (D) du transistor MOS sur substrat SOI ;
- à partir de la valeur de la tension de bandes plates (Vfb) déterminée à l'étape d'ajustement (AJU) et des caractéristiques Cgb(Vgs) et Cgc(Vgs), calculer (CHARGE) la densité surfacique de porteurs N(Qtot) en fonction de la tension Vgs ;
- à partir de la densité surfacique de porteurs N(Qtot), déterminer (ENE) l'énergie E, définie par la relation E= qVgs + X + (Ec-Ef), en fonction du nombre de porteurs Ntot, q étant la charge de l'électron, X l'affinité électronique du semiconducteur du canal (Ch), Ef le niveau de Fermi du semi-conducteur de canal (Ch), Ec l'énergie de la bande de conduction du semi-conducteur du canal (Ch) à son interface avec l'oxyde de grille face avant (DGAV) ;
- obtenir à l'aide d'un ajustement linéaire (LIN) de E en fonction du nombre de porteurs le travail de sortie effectif (Weff) de la grille avant et l'épaisseur (EOTfox) effectif de l'oxyde de grille face avant (DGAV).

**Patentansprüche**

1. Messverfahren (MES) eines Parametersatzes (PAR) eines Transistors vom Typ MOS auf Substrat vom Typ SOI (Silicon On Insulator), wobei der genannte Parametersatz (PAR) wenigstens die Flachbandspannung (Vfb) auf der Rückseite des versenkten Sauerstoffs (DGAR) enthält, wobei das genannte Verfahren die folgenden Schritte umfasst:

• Anwenden (APP) einer Haupt-Gleichspannung Vgs und einer Wechselspannung v(t) auf das Gitter der Vorderseite (GAV) des Transistors, wobei die Haupt-Gleichspannung Vgs einen vorbestimmten Wertebereich abtasten kann;

• Anwenden (BIAS) darüber hinaus einer Spannung -Vbias auf das Gitter der Vorderseite (GAV) und auf die Source- (S) und Drain-Elektroden (D), wobei die Spannung -Vbias einen vorbestimmten Wertebereich abtasten kann;

• Für einen bestimmten Wert der Spannung -Vbias Messen (MIG) des elektrischen Stroms Ig(t), der aus dem Gitter der Rückseite stammt in Abhängigkeit von Vgs, und ausgehend von dieser Messung Bestimmen der Kapazität zwischen dem Gitter der Vorderseite und der Rückseite des Substrats des Transistors derart, dass das Merkmal $C_{gb\,Bias}$ (Vgs; Vbias) erreicht wird;

• Variieren des Wertes der Spannung -Vbias und für jeden Wert von Vbias Messen (MIG_BIAS) des Merkmals $C_{gb,\,Bias}$ (Vgs; Vbias) durch Variieren Vgs derart, dass eine Merkmalsgruppe $C_{gb,\,Bias}$ (Vgs; Vbias) erhalten wird, wobei jedes Merkmal einem unterschiedlichen Wert von - Vbias entspricht;

• Ausgehend von der Gruppe von Merkmalen $C_{gb,\,Bias}$ (Vgs; Vbias) Bestimmen (CARAC) der Gruppe von Merkmalen $C_{gb,\,Bias}$ (Vgb; Vbias), wobei Vgb die Spannung zwischen dem Gitter der Vorderseite und dem Gitter der Rückseite ist;

• Bestimmen (ENV) des Merkmals $C_{gb,\,Bias}$ (Vgb), wobei dieses Merkmal die Hülle der Gruppe von Merkmalen $C_{gb,\,Bias}$ (Vgb; Vbias) ist;

• Bestimmen (AJU) des Parametersatzes durch Realisieren einer Anpassung zwischen dem Merkmal $C_{gb,\,Bias}$ (Vgb) und einem theoretischen Modell, das das Verhalten eines Transistors vom Typ MOS auf massivem Substrat beschreibt, wobei die genannte Anpassung auf den Wertebereich von Vgb begrenzt ist, für die der Kanal des Transistors im Verarmungsbetrieb ist.

2. Verfahren (MES) gemäß dem voranstehenden Anspruch, **dadurch gekennzeichnet, dass** der Parametersatz (PAR) zusätzlich zu der Flachbandspannung (Vfb) an der Rückseite des versenkten Sauerstoffs wenigstens einen der folgenden Parameter umfasst:

   - die äquivalente Sauerstoffdicke (EOT);
   - die effektive Ausgangsarbeit des Gittermaterials (Weff).

3. Verfahren (MES) gemäß dem voranstehenden Anspruch, **dadurch gekennzeichnet, dass** die äquivalente Sauerstoffdicke (EOT) der kumulierten Dicke der Sauerstoff-, Kanal- und versenkten Sauerstoffschichten entspricht.

4. Verfahren (MES) gemäß einem der voranstehenden Ansprüche, **dadurch gekennzeichnet, dass** beim Anwendungsschritt (MIG) der Spannung -Vbias auf das Gitter der Vorderseite GAV und auf die Source- S und Drain-Elektroden D und des Messschritts (MIG_BIAS) der Gruppe von Merkmalen $C_{gb,\,Bias}$ (Vbs; Vbias) die Spannung -Vbias allmählich und nach Phasen auf den zwei Anschlüssen erhöht wird, wobei die zwei Anschlüsse jeweils das Gitter der Vorderseite (GAV) und die Source- S und Drain-Elektroden D sind.

5. Verfahren (MES) gemäß einem der voranstehenden Ansprüche, **dadurch gekennzeichnet, dass** die Spannung Vbias abwechselnd auf den zwei Anschlüssen, dem Gitter der Vorderseite (GAV) und Source- S und Drain-Elektroden (D) erhöht wird.

6. Verfahren (MES) gemäß einem der voranstehenden Ansprüche, **dadurch gekennzeichnet, dass** es darüber hinaus die folgenden Schritte umfasst:

   - ausgehend von einer Messung vom Typ C(Vgs) Bestimmen der Merkmale Cgc(Vgs) und Cgb(Vgs), wobei Vgs die angewendete Spannung zwischen dem Gitter der Vorderseite (GAV) und den SourceS und Drain-Elektroden (D) des Transistors MOS auf dem Substrat SOI ist;
   - ausgehend von dem Wert der im Anpassungsschritt (AJU) bestimmten Flachbandspannung (Vfb) und der Merkmale Cgb(Vgs) und Cgc(Vgs) Berechnen (CHARGE) der Oberflächendichte von Trägern N(Qtot) in Abhängigkeit von der Spannung Vgs;
   - ausgehend von der Oberflächendichte von Trägern N(Qtot) Bestimmen (ENE) der Energie E, die durch das Verhältnis E = qVgs + X + (Ec-Ef) bestimmt wird, in Abhängigkeit von der Anzahl von Trägern Ntot, wobei q die Ladung des Elektrons ist, X die elektronische Affinität des Halbleiters des Kanals (Ch) ist, Ef des Femi-Niveau des Halbleiters des Kanals (Ch) ist, Ec die Energie des Leitungsbandes des Halbleiters des Kanals (Ch) an seiner Schnittstelle mit dem Sauerstoff des Gitters der Vorderseite (DGAV) ist;
   - Erhalten der effektiven Ausgangsarbeit (Weff) des vorderen Gitters und der effektiven Dicke (EOTfox) des Sauerstoffs des Gitters der Vorderseite (DGAV) mithilfe einer linearen Anpassung (LIN) von E in Abhängigkeit von der Anzahl von Trägern.

**Claims**

1. Method (MES) for measuring a set of parameters (PAR) of a transistor of the MOS type on a substrate of the SOI (Silicon On Insulator) type, said set of parameters (PAR) including at least the flatband voltage (Vfb) at the rear face of the buried oxide (DGAR), said method comprising the following steps:

   • Applying (APP) to the front face gate (GAV) of the transistor a direct main voltage Vgs and an alternating voltage v(t), with the direct main voltage Vgs able to sweep a predetermined range of values;
   • Applying (BIAS) in addition a -Vbias voltage to the front face gate (GAV) and to the source (S) and drain (D) electrodes, with the -Vbias voltage able to sweep a predetermined range of values;
   • For a given value of the -Vbias voltage, measuring (MIG) the electric current Ig(t) coming from the rear face gate according to Vgs and determining from this measurement the capacity between the front face gate and the rear face of the substrate of the transistor, in such a way as to obtain the characteristic $C_{gb,Bias}$(Vgs; Vbias);
   • Varying the value of the -Vbias voltage and for each value of Vbias measuring (MIG_BIAS) the characteristic $C_{gb,Bias}$(Vgs; Vbias) by varying Vgs in such a way as to obtain a set of characteristics Cgb,Bias(Vgs; Vbias), with each characteristic corresponding to a different value of -Vbias;
   • Using the set of characteristics $C_{gb,Bias}$(Vgs; Vbias), determining (CARAC) the set of characteristics $C_{gb,Bias}$(Vgb; Vbias), Vgb being the voltage between the front face gate and the rear face gate;
   • Determining (ENV) the characteristic $C_{gb,Bias}$(Vgb), this characteristic being the envelope of the set of characteristics $C_{gb,Bias}$(Vgb; Vbias);
   • Determining (AJU) the set of parameters by carrying out an adjustment between the characteristic $C_{gb,Bias}$(Vgb) and a theoretical model that describes the behaviour of a transistor of the MOS type on a bulk substrate, said adjustment being limited to the range of values of Vgb for which the channel of the transistor is in depletion regime.

2. Method (MES) according to the preceding claim **characterised in that** the set of parameters (PAR) comprises, in addition to the flatband voltage (Vfb) at the rear face of the buried oxide, at least one of the following parameters:

   - the equivalent thickness of oxide (EOT);
   - the effective output work of the gate metal (Weff).

3. Method (MES) according to the preceding claim **characterised in that** the equivalent thickness of oxide (EOT) corresponds to the total thickness of the layers of oxide, channel and buried oxide.

4. Method (MES) according to one of the preceding claims **characterised in that** during the step of applying (MIG) the -Vbias voltage to the front face gate GAV and to the source S and drain D electrodes and during the step of measuring (MIG_BIAS) the set of characteristics $C_{gb,Bias}$(Vbs; Vbias), the -Vbias voltage is increased progressively and in stages over the two connections, with the two connections being respectively the front face gate (GAV) and the source (S) and drain (D) electrodes.

5. Method (MES) according to one of the preceding claims **characterised in that** the Vbias voltage is increased alternatively over the two connections, front face gate (GAV) and source (S) and drain (D) electrodes.

6. Method (MES) according to one of the preceding claims **characterised in that** it further comprises the following steps:

   - from a measurement of the C(Vgs) type determining (MES_Vgs) the characteristics Cgc(Vgs) and Cgb(Vgs), with Vgs being the voltage applied between the front face gate (GAV) and the source (S) and drain (D) electrodes of the transistor MOS on substrate SOI;
   - from the value of the flatband voltage (Vfb) determined in the step of adjusting (AJU) and from the characteristics Cgb(Vgs) and Cgc(Vgs), calculating (CHARGE) the surface density of carriers N(Qtot) according to the voltage Vgs;
   - from the surface density of carriers N(Qtot), determining (ENE) the energy E, defined by the relation E= qVgs + X + (Ec-Ef), according to the number of carriers Ntot, with q being the charge of the electron, X the electron affinity of the semiconductor of the channel (Ch), Ef the Fermi level of the semi-conductor of channel (Ch), Ec the energy of the conduction band of the semi-conductor of the channel (Ch) at the interface thereof with the oxide of the front face gate (DGAV);

- obtaining using a linear adjustment (LIN) of E according to the number of carriers the effective output work (Weff) of the front gate and the effective thickness (EOTfox) of the oxide of the front face gate (DGAV).

**Fig. 1a**

M

O

SC

GAV

S

D

PSAR

Métal

oxyde

P+

ISOLANT

P+

ISOLANT

N+

Substrat N

**Fig. 1b**

Fig. 2a

Fig. 2b

**Fig. 3a**

**Fig. 3b**

## Fig. 4a

GAV

DGAV

Ch

DGAR

SUB

Vg

GAR

Vb

## Fig. 4b

GAV

S

D

GAR

DGAV

Métal

Oxyde

ISOLANT

P+

Film silicium

P+

ISOLANT

N+

Oxyde enterré

SUB

Substrat N

DGAR

Ch

**Fig. 4c**

**Fig. 4d**

**Fig. 5a**

**Fig. 5b**

**Fig. 6**

**Fig. 7**

**Fig. 7a**

**Fig. 7b**

**Fig. 8a**

**Fig. 8b**

**Fig. 9**

Fig. 10

Fig. 11

**Fig. 12**

**Fig. 13**

**Fig. 14**

Fig. 15

Fig. 16

**Fig. 17**

**Fig. 18**

| Ef-Ec [eV] | N(Qtot)PMOS_Si | Ef-Ec [eV] | N(Qtot)NMOS_Si |
|---|---|---|---|
| -1,49 | 1,75E+17 | -0,03 | -3,17E+15 |
| -1,48 | 1,67E+17 | -0,01 | -8,82E+15 |
| -1,46 | 1,59E+17 | 0,02 | -1,47E+16 |
| -1,45 | 1,51E+17 | 0,04 | -2,09E+16 |
| -1,44 | 1,43E+17 | 0,06 | -2,73E+16 |
| -1,42 | 1,35E+17 | 0,08 | -3,39E+16 |
| -1,41 | 1,27E+17 | 0,10 | -4,08E+16 |
| -1,40 | 1,19E+17 | 0,11 | -4,78E+16 |
| -1,38 | 1,11E+17 | 0,13 | -5,49E+16 |
| -1,37 | 1,04E+17 | 0,15 | -6,22E+16 |
| -1,35 | 9,62E+16 | 0,16 | -6,96E+16 |
| -1,34 | 8,87E+16 | 0,18 | -7,72E+16 |
| -1,32 | 8,13E+16 | 0,19 | -8,48E+16 |
| -1,31 | 7,40E+16 | 0,21 | -9,25E+16 |
| -1,29 | 6,68E+16 | 0,22 | -1,00E+17 |
| -1,27 | 5,97E+16 | 0,24 | -1,08E+17 |
| -1,25 | 5,27E+16 | 0,25 | -1,16E+17 |
| -1,24 | 4,59E+16 | 0,26 | -1,24E+17 |
| -1,22 | 3,92E+16 | 0,27 | -1,32E+17 |
| -1,20 | 3,27E+16 | 0,29 | -1,40E+17 |
| -1,18 | 2,64E+16 | 0,30 | -1,49E+17 |
| -1,15 | 2,02E+16 | | |
| -1,13 | 1,43E+16 | | |
| -1,11 | 8,56E+15 | | |
| -1,08 | 3,03E+15 | | |

# Fig. 19

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **C. LEROUX et al.** Accurate détermination of flat band voltage in advanced MOS structures. *Microelectronics Reliability,* 2007, vol. 47, 660-664

- **M. MOHAMAD.** *Reliable Gate Stack and Substrate Parameter Extraction based on C-V measurements for 14 nm node FDSOI technology*